# EUROPÄISCHE PATENTANMELDUNG

(11) **EP 2 605 089 A1**
(43) Veröffentlichungstag der Anmeldung: **19.06.2013**
(21) Anmeldenummer: 11193050.9
(22) Anmeldetag: 12.12.2011
(51) Int. Cl.: G05B 19/042, H01R 9/26, H05K 7/14

(54) **Modular konfigurierbares Hardwaresystem und Verfahren zum Betreiben des Hardwaresystems**

(71) Anmelder: Benteler Automobiltechnik GmbH, 33102 Paderborn (DE)
(72) Erfinder: Roser, Jürgen, 38442 Wolfsburg (DE); Grünewald, Marek, 38118 Braunschweig (DE); Knye, Florian, 38104 Braunschweig (DE)
(74) Vertreter: Ksoll, Peter

(57) **Zusammenfassung**

Die vorliegende Erfindung betrifft ein Hardwaresystem (1) zur Modellbildung, Messung, Prüfung, Regelung und/oder Steuerung von elektrischen Schaltkreisen und/oder Datennetzen und/oder Sensoren und/oder Aktoren, insbesondere zum Einsatz in Automotiveanwendungen, wobei das Hardwaresystem (1) dadurch gekennzeichnet ist, dass in ein Grundmodul (2) Einsteckmodule (7) lösbar einsteckbar sind und das Hardwaresystem (1) hierüber modular konfigurierbar ist. Das erfindungsgemäße Hardwaresystem (1) eignet sich insbesondere zur Verwendung in Prototypenfahrzeugen. Ein weiterer Bestandteil der Erfindung ist ein Verfahren zur Autoadressierung des erfindungsgemäßen Hardwaresystems (1), wobei die Autoadressierung über einen Neustart und/oder modulare Erweiterung des Hardwaresystems (1) mit einem Zwischenmodul (3) durchgeführt wird.

## Beschreibung

Die vorliegende Erfindung betrifft ein Hardwaresystem zur Modellbildung, Messung, Prüfung, Regelung und/oder Steuerung gemäß den Merkmalen im Oberbegriff von Patentanspruch 1.

Die vorliegende Erfindung betrifft weiterhin die Verwendung eines Hardwaresystems gemäß den Merkmalen im Patentanspruch 12.

Die vorliegende Erfindung betrifft darüber hinaus ein Verfahren zur Autoadressierung eines Hardwaresystems gemäß den Merkmalen im Patentanspruch 17.

Bei der aktuellen Entwicklung von Kraftfahrzeugen spielt der Einbau von Elektronikkomponenten eine immer stärkere Rolle. Zu den originären elektrischen Verbrauchern in einem Kraftfahrzeug, wie beispielsweise der Motorelektronik oder aber der Beleuchtungsanlage, kommt eine Vielzahl an elektrischen Fahrerassistenz- sowie Komfortsystemen.

Auf seiten der Fahrerassistentsysteme gibt es Basiskomponenten, über die nahezu jedes neu gebaute Fahrzeug verfügt. Hierzu zählen ein Antiblockiersystem sowie ein elektronisches Stabilitätsprogramm. Beide Systeme nutzen eine Vielzahl von Sensoren und Aktoren, die an verschiedenen Orten des Kraftfahrzeugs angeordnet sind. So gibt es beispielsweise Radsensoren, die direkt im Bereich der Räder angeordnet sind, sowie Beschleunigungssensoren, die zentral im Kraftfahrzeug positioniert sind. Zur Auswertung der Sensorsignale sind wiederum verschiedene Steuergeräte in dem Kraftfahrzeug angeordnet, die über Regeleingriffe in die Motorelektronik oder aber das Bremssystem kritische Fahrzustände vermeiden.

Darüber hinaus verfügen Kraftfahrzeuge heutzutage über Sensoren, die permanent Umgebungsdaten sammeln und auswerten und somit einen Rückschluss über die aktuellen klimatischen Bedingungen sowie die Wetterlage oder auch die Stausituation zulassen. Auf Basis dieser Datenauswertung verändern sich dann die Betriebsfunktionen für Scheibenwischer, Klimaautomatik oder aber auch Stabilitätseingriffe in das Fahrverhalten. Beispielsweise wird bei regnerischem Wetter die Gebläsefunktion der Klimaautomatik auf die Scheiben erhöht sowie die Scheibenwischersensibilität verstärkt, so dass der Fahrer stets freie Sicht erhält.

Zur Vernetzung der einzelnen Elektronikkomponenten innerhalb des Kraftfahrzeugs, insbesondere der Sensoren, Steuergeräte und Aktoren untereinander, sind diese über Kabelleitungen mit dem Bordnetz und miteinander gekoppelt. Da die stetig zunehmende Vielzahl von Elektronikbauteilen eine schier unendliche Zahl verschiedener Kabelleitungen erfordern würde, kommunizieren die Elektronikkomponenten innerhalb eines Kraftfahrzeugs über mindestens ein BUS-Signal untereinander. Zumeist handelt es sich dabei um einen Can-BUS. Durch die Verwendung eines BUS-Kommunikationsweges der einzelnen Elektronikkomponenten untereinander ist es möglich, mehrere Komponenten an eine entsprechende Datenleitung zu koppeln. Die Datenleitung selber besteht dabei wiederum aus zwei, drei oder mehr einzelnen Kabelleitungen. Über die Datenleitung ist es möglich, verschiedene Kommunikationssignale zu versenden, wobei sich die einzelnen Elektronikbauteile, wie Steuergeräte, Sensoren und Aktoren, dann die jeweils relevanten Daten aus der Kommunikationsleitung auslesen bzw. Daten über die Kommunikationsleitung senden.

In einem Kraftfahrzeug werden jedoch verschiedenste Bauteile von Kraftfahrzeugzulieferern verbaut. Dabei gilt es, die Zuliefererbauteile der verschiedensten Zulieferhersteller auf einen Standard des jeweiligen Kraftfahrzeugherstellers oder aber des jeweiligen Kraftfahrzeugtyps zu bringen, so dass diese kompatibel in dem Kraftfahrzeug selber miteinander kommunizieren und agieren.

Bei technischen Verbesserungen während des Produktlebenszyklus einer Baureihe eines Kraftfahrzeugs, beispielsweise der Seriennachrüstung eines neueren Navigationssystems im Zuge einer Produktauffrischung, gilt es, Elektronikkomponenten mit neuesten Standards in ein bereits Jahre älteres, bestehendes Elektroniksystem zu implementieren.

Zur Entwicklung von Kraftfahrzeugen sind daher für jedes einzelne Bauteil aufwendige Tests und Probeläufe zu absolvieren. Im Anschluss hieran werden die einzelnen Komponenten zu Baugruppen zusammengefügt, die wiederum Tests und Probeläufe absolvieren. Alle Bauteilkomponenten werden dann in Prototypenfahrzeugen vereint und auch hier wiederum ausgiebig getestet. Die Erkenntnis aus der Entwicklung der Komponenten sowie der Prototypenkraftfahrzeuge fließen dann in Vorserienmodelle ein, wobei die bis dahin gesammelten Erkenntnisse eine spätere Volumenproduktion des Kraftfahrzeugmodels, insbesondere ohne Elektronikprobleme, zulassen.

Damit ein Elektronikbauteil eigenständig entwickelt und getestet werden kann, ohne in einem Kraftfahrzeug selber eingebaut zu sein, bedarf es der Simulation der Kraftfahrzeugumgebung. Hierzu hat sich die Hardware in the loop Methode etabliert, bei der eine reale elektronische Bauteilkomponente oder aber eine reale mechatronische Bauteilkomponente über ihre Ein- und Ausgänge an eine simulierte Umgebung angeschlossen wird. Der Simulator simuliert dabei in einem Zusammenspiel aus Hardware und Software die reale Umgebung des Gesamtsystems, also des Kraftfahrzeugs oder aber einer Unterbaugruppe einer Baugruppe des Kraftfahrzeugs. Hierzu bedarf es entsprechender Hardware sowie Entwicklungssoftware bei der Entwicklung des Bauteils. Als Hardware fungieren zumeist Computer, die in Laboren bzw. auf Prüfständen in Großgehäusen als Einschubsteckplätze modular aufgebaut sind. Solche Computergehäuse sind stationär an den Laborbetrieb gebunden und aufgrund ihrer äußeren Abmessungen sowie ihrer Verkablung zu den zu erprobenden oder zu evaluierenden Bauteilen stationär gebunden. Zur Erweiterung der Funktionsfähigkeit einer entsprechenden Prüfstandshardware werden neue Einsteckmodule eingesteckt, die dann eine weitere Reihe von Sensoren oder Aktoren ansteuern oder aber auswerten kann. Hierbei kommt es unter Umständen zu hardwaretechnischen und auch softwaretechnischen Kompatibilitätsproblemen auf Seiten des Simulators.

Zur Auswertung und Bedienung eines Simulators bedarf es wiederum eines Personal Computers mit Eingabemaske, über die dann die Simulationsumgebung erschaffen, simuliert und ausgewertet wird.

Zur Erprobung in einem Kraftfahrzeug, also auch zur mobilen Erprobung während einer Testfahrt, eignen sich vorerwähnte Simulatoren dann wiederum nicht. Hier wird zumeist auf Dummies oder aber Dongel zurückgegriffen, die bei Testfahrten ausschließlich eine Auswertung oder aber Simulation vornehmen, deren Ergebnisse im Nachhinein ausgewertet werden. Es ist jedoch auch mobile Testhardware bekannt, bei der entsprechende Gehäuse in einem Kraftfahrzeug auf dem Beifahrersitz oder aber im Kofferraum angeordnet werden, in die dann wiederum verschiedenste Einsteckmodule einbaubar sind, um so für einen jeweiligen Anwendungsfall die erforderliche Testhardware bereit zu stellen.

Aufgabe der vorliegenden Erfindung ist es, ausgehend vom Stand der Technik, ein modular konfigurierbares Hardwaresystem bereit zu stellen, das sowohl stationär als auch mobil einsetzbar ist und das gegenüber aus dem Stand der Technik bekannten Hardwaresystemen bedeutend einfacher einsetzbar ist.

Die zuvor genannte Aufgabe wird mit einem Hardwaresystem gemäß den Merkmalen im Patentanspruch 1 gelöst.

Die zuvor genannte Aufgabe wird weiterhin mit einer Verwendung des erfindungsgemäßen Hardwaresystems gemäß den Merkmalen im Patentanspruch 12 gelöst.

Die zuvor genannte Aufgabe wird weiterhin mit einem Verfahren zur Autoadressierung eines erfindungsgemäßen Hardwaresystems gemäß den Merkmalen im Patentanspruch 17 gelöst.

Vorteilhafte Ausführungsvarianten der vorliegenden Erfindung sind Bestandteil der abhängigen Patentansprüche.

Das erfindungsgemäße Hardwaresystem zur Modellbildung, Messung, Prüfung, Regelung und/oder Steuerung von elektrischen Schaltkreisen und/oder Datennetzen und/oder Sensoren und/oder Aktoren, insbesondere zum Einsatz in Automotiveanwendungen, weist ein Grundmodul mit in das Grundmodul einsteckbaren Einsteckmodulen auf. Es ist dadurch gekennzeichnet, dass das Einsteckmodul lösbar in das Grundmodul einsteckbar ist und über das Einsteckmodul ein externer Sensor und/oder Aktor ansteuerbar ist oder dass über das Einsteckmodul ein externes Datennetz auslesbar ist.

Im Rahmen der Erfindung können somit durch optional in das Grundmodul lösbar einsteckbare Einsteckmodule verschiedenste Aktoren, Sensoren ausgelesen und/oder gesteuert bzw. geregelt werden. Ebenfalls ist es möglich, Datennetze mit verschiedenen Datennetzstandards, beispielsweise einen Ethernet-Standard oder aber auch einem CANBUS-Standard auszulesen bzw. Daten in ein solches Datennetz einzuspeisen. Ein solches Hardwaresystem eignet sich insbesondere zur Erprobung von Bauteilen oder aber gesamten Bordnetzen von Kraftfahrzeugen.

Das erfindungsgemäße Hardwaresystem ist hierzu besonders bevorzugt modulartig erweiterbar, indem dem Grundmodul verschiedene Zwischenmodule und/oder ein Deckelmodul zugeordnet werden. Im Rahmen der Erfindung sind die einzelnen Module schichtartig bzw. modulartig aufeinander stapelbar und ein jeweiliges Modul bildet eine Modulebene, wobei in die Modulebene wiederum Einsteckmodule lösbar einsteckbar sind. Hierdurch ist es möglich, eine Vielzahl, insbesondere ein gesamtes Kraftfahrzeug mit einem entsprechenden erfindungsgemäßen Hardwaresystem zu vernetzen. Es können 50, 60 oder auch 70 verschiedene Aktoren, Sensoren oder auch mehrere verschiedene Datennetze an das erfindungsgemäße Hardwaresystem angeschlossen werden.

Das Gehäuse des Hardwaresystems ist bevorzugt aus einem metallischen Werkstoff ausgebildet, insbesondere aus Leichtmetall, ganz besonders bevorzugt aus Aluminium. Das Gehäuse vereint somit verschiedene Eigenschaften zu einem Optimum, weshalb es mechanisch robust, elektrisch abschirmend sowie leicht ist. Das Hardwaresystem kann somit aufgrund seines Gewichts von mitunter nur wenigen Hundert Gramm leicht transportiert werden, ist bei mechanischen Einflüssen, die bei einem Prüfstandsaufbau oder während eines Tests in einem Prototypenfahrzeug auftreten können, hinreichend geschützt, so dass die darin befindliche Elektronik sowie die elektrischen Bauteile nicht beschädigt werden.

Bei einer modularen Erweiterung von mehr als einem Dutzend Zwischenmodulen wird durch das metallische Gehäuse eine ausreichende mechanische Stabilität sichergestellt. Insbesondere handelt es sich bei dem Gehäuse um Massivbauteile, insbesondere massive Fräsbauteile. Hierdurch wird die modulare Stapelbarkeit gegenüber Blechformbauteilen erleichtert sowie bei mehrjähriger Nutzung mit Hunderten von mechanischen Koppelungen der einzelnen Module untereinander die Robustheit den einzelnen Komponenten des Hardwaresystems eine ausreichende mechanische Stabilität gegeben, so dass diese auch unter widrigen und harten Nutzungsbedingungen einwandfrei einsetzbar sind.

Zwischen den einzelnen Modulen, also zwischen dem Grundmodul, dem Zwischenmodul und dem Deckelmodul oder aber zwischen mehreren Zwischenmodulen wird besonders bevorzugt eine Isollerungsschicht angeordnet, insbesondere aus einem Kunststoff oder Plastikwerkstoff, ganz besonders bevorzugt aus Plexiglas. Die Isolierungsschicht selber kann zur optischen Kenntlichmachung der einzelnen eingesetzten Zwischenmodule eingesetzt werden, indem verschiedene Farben bei dem Kunststoff oder Plastikwerkstoff verwendet werden. Im Falle des Einsatzes eines transparenten Plastikwerkstoffs, insbesondere von einem Plexiglas, ist es wiederum möglich, über in dem Hardwaresystem angeordnete Leuchtmittel, beispielsweise Leuchtdioden, verschiedene Betriebszustände direkt ablesbar anzuzeigen. Beispielsweise kann eine optische Rückmeldung des korrekten Einsteckens eines Einsteckmoduls über rot und grün dargestellt werden. Ebenfalls ist ein Fehler über eine beispielsweise rot grüne Darstellung direkt anzeigbar.

In einem Hardwaresystem, das mit mitunter mehr als 50 Einsteckmodulen versehen ist, kann der Bediener somit sofort erkennen, auf welcher Modulebene ein Fehler vorliegt und gegebenenfalls an welchem Einsteckmodul. Dabei ist die farbliche Signalgebung nicht auf die Farben rot grün begrenzt, sondern es kann das gesamte, für das menschliche Auge wahrnehmbare Farbspektrum eingesetzt werden, um verschiedene Betriebszustände oder aber Bereitschaftssignale optisch anzuzeigen.

Ebenfalls kann im Rahmen der Erfindung die Isolierungsschicht über das Gehäuse überstehend ausgebildet werden, so dass die Isolierungsschicht die Einsteckmodule mit abdeckt. Hierdurch können eine elektrische sowie eine EMV-Isolierung der Einsteckmodule untereinander erfolgen. Ebenfalls können die Module untereinander mechanisch voneinander getrennt oder aber geschützt werden, so dass bei mechanischen ungewollten Einflüssen auf das Hardwaresystem ein Abknicken oder eine sonstige Beschädigung des eingesteckten Einsteckmoduls vermieden wird.

Im Rahmen der Erfindung kann zwischen den einzelnen Modulen jedoch auch eine leitende Schicht angeordnet werden, insbesondere wenn das Hardwaresystem in einem Hochspannungsbereich eingesetzt wird. Im Rahmen der Erfindung wäre es vorstellbar, dass das Hardwaresystem über das Gehäuse geerdet wird.

Weiterhin besonders bevorzugt sind die einzelnen Module über eine formschlüssige Koppelung miteinander lösbar verbunden. Insbesondere handelt es sich bei der formschlüssigen Koppelung um eine Schraubverbindung bzw. eine Schnellverbindung, wobei insbesondere die Schnellverbindung oder die Schraubverbindung nur zwischen einem Modul und dem benachbarten Modul ausgebildet ist. Hierdurch ist es möglich, die einzelne Schraubverbindung zwischen zwei Modulen zu lösen, so dass bei einem Hardwaresystem, das beispielsweise aus zehn Modulen in Sandwichbauweise aufgebaut ist, ein mittleres Modul entnehmbar ist, ohne dass das gesamte Hardwaresystem demontiert werden muss. Somit ist die Schraubverbindung des mittleren Moduls lösbar, das mittlere Modul entnehmbar und die verbleibenden Module sind wieder lösbar miteinander koppelbar. Die Schraubverbindung der verbleibenden Module sind somit wiederum miteinander koppelbar, so dass das Hardwaresystem bzw. das Gehäuse mechanisch robust und sicher lagefixiert miteinander verbunden ist.

Weiterhin besonders bevorzugt weist das Grundmodul und/oder das Deckelmodul und/oder die Zwischenmodule mindestens einen Einsteckplatz auf, vorzugsweise weist ein Zwischenmodul vier Einsteckplätze auf. Besonders bevorzugt ist ein Zwischenmodul derart aufgebaut, dass jeweils zwei Einsteckmodule nebeneinander angeordnet werden, wobei die anderen zwei Einsteckmodule auf einer gegenüberliegenden Seite des Zwischenmoduls einsteckbar sind und das Zwischenmodul spiegelsymmetrisch aufgebaut ist. Hierdurch ist es möglich, das Hardwaresystem insbesondere für Einsatzgebiete bereit zu stellen, die eine redundante Überwachung oder aber redundante Steuerung erfordern. Die jeweils auf den spiegelsymmetrischen Seiten gegenüberliegenden Einsteckmodule können zeitgleich über das Hardwaresystem angesteuert werden, wobei jeweils nur eine Rechenleistung benötigt wird, da die Signale parallel über die Zwischenebene an die zwei spiegelsymmetrisch angeordneten Einsteckmodule weitergegeben werden können. Ebenfalls erlaubt diese Anordnung einen besonders kompakten Aufbau sowie die Unterbringung möglichst vieler Einsteckmodule auf kleinem Raum.

Weiterhin bevorzugt sind zwei Hardwaresysteme miteinander koppelbar, die über jeweils einen Einsteckplatz miteinander koppelbar sind, wobei die Hardwaresysteme nebeneinander anordnenbar sind. Im Rahmen der Erfindung ist es auch möglich, zwei Hardwaresysteme über einen anderen Adapter, der beispielsweise im Austausch zu einem Deckelmodul modular auf die zwei Hardwaresysteme aufgesetzt wird, zu koppeln. Im Rahmen der Erfindung ist es ebenfalls vorstellbar, drei oder vier Hardwaresysteme, die einen jeweils schichtweisen bzw. turmartigen eigenen Aufbau besitzen, nebeneinander anzuordnen und miteinander zu koppeln.

Hierbei sind dann bevorzugt die mindestens zwei nebeneinander angeordneten Hardwaresysteme über jeweils das andere Hardwaresystem bedienbar. Die zwei nebeneinander angeordneten Hardwaresysteme sind derart miteinander kompatibel, dass sie als ein Gesamthardwaresystem ansteuerbar sind.

Besonders bevorzugt ist das Hardwaresystem mit einer externen Datenauswerteeinheit koppelbar, vorzugsweise mit einem Computer. Hierüber ist es möglich, das Hardwaresystem über den Computer zu bedienen und somit wiederum über das Hardwaresystem die an das Hardwaresystem angeschlossenen Sensoren und Aktoren oder sonstigen Peripheriebauteile über den Computer zu bedienen. Hierzu wird besonders bevorzugt ein Einsteckmodul in das Hardwaresystem eingesetzt, das die Schnittstelle zwischen externer Datenauswerteeinheit bzw. Computer und Hardwaresystem darstellt.

Zum korrekten Sitz der Einsteckmodule in dem Hardwaresystem selber sind diese weiterhin besonders bevorzugt arretierbar, insbesondere über eine Schnellverbindung. Bei der Schnellverbindung handelt es sich ganz besonders bevorzugt um eine Magnetverbindung. Die Magnetverbindung sorgt im Zusammenspiel mit dem Gehäuse des Hardwaresystems für eine schnelle Anschluss- bzw. Einschubmöglichkeit des Einsteckmoduls sowie einen festen Sitz. Bei Einstecken des Einschubmoduls wird dieses aufgrund der Magnetwirkung von dem Gehäuse angezogen, weshalb ein fehlerfreies und sicheres Einstecken des Einsteckmoduls in das Gehäuse des Hardwaresystems sichergestellt wird. Durch die Magnetkraft entsteht bei vollständigem Einstecken des Einsteckmoduls ein akustisches Bestätigungsgeräusch in Form eines Klackens. Dies gibt dem Bediener eine Rückmeldung, dass er das jeweilige Einsteckmodul korrekt in das Gehäuse eingesteckt hat.

Die Einsteckmodule selber weisen einen kartenartigen Einsteckbereich sowie einen Kopfbereich, wobei der Einsteckbereich im Wesentlichen vollständig in den Einsteckschacht des Gehäuses einsteckbar ist. In dem Kopfbereich des Einsteckmoduls sowie vorzugsweise in Teilen des Einsteckbereichs sind verschiedene Elektronikkomponenten untergebracht, die für den jeweiligen Anwendungsfall des Einsteckmoduls benötigt werden.

So ist beispielsweise bei einem Einsteckmodul für einen Aktuator im Kopfbereich ein Speicherbaustein angeordnet, auf dem eine Treibersoftware des Aktuators abgelegt ist. Ebenfalls kann in dem Kopfbereich eines Einsteckmoduls ein A/D-Wandler, aber auch ein Spannungswandler oder aber auch ein Potentiometer angeordnet sein. Erfindungsgemäß wird hierdurch ein Wärmeeintrag, der bei Regelung, Steuerung oder Auswertung der an das Hardwaresystem angeschlossenen Peripheriebauteile in dem Einsteckmodul entsteht, nicht in das Gehäuse des Hardwaresystems eingeleitet. Ebenfalls erfolgt die Wärmeentwicklung nicht im Inneren des Gehäuses des Hardwaresystems, weshalb auf aufwendige Verfahren sowie Mittel zum Kühlen des Hardwaresystems verzichtet werden kann. Hierdurch reduzieren sich die geometrischen Abmessungen des Hardwaresystems und ein Bauteilversagen in Form von Hitzeentwicklung wird vermieden.

Im Rahmen der Erfindung weist das Hardwaresystem ein Gehäuse auf, das modular optional erweiterbar ist. Das Gehäuse setzt sich aus einem Grundmodul, optionalen Zwischenmodulen und einem Deckelmodul zusammen, wobei die einzelnen Module untereinander über den systemeigenen Bus des Hardwaresystems kommunizieren. Jede Modulebene weist einen Controller auf, wobei in dem Grundmodul ein Mastercontroller angeordnet ist, und die anderen Ebenen diesem Mastercontroller als Slavecontroller unterstellt werden.

Das erfindungsgemäße Hardwaresystem ist beliebig erweiterbar, wobei die einzelnen Modulebenen durch beliebige Anordnung von Zwischenmodulen turmartig und/oder sandwichartig aufeinandersetzbar sind. In die einzelnen Modulebenen sind im Rahmen der Erfindung Einsteckmodule lösbar einsteckbar, die ein einfaches und sicheres Anschließen von externen Reglern und/oder Messsensoren und/oder Aktoren ermöglichen sowie Datennetze über das Einsteckmodul auslesbar und/oder übersetzbar sind.

Bei Reglern, Sensoren und/oder Aktoren handelt es sich dabei im Rahmen der Erfindung um alle erdenklichen Sensoren, Aktoren und/oder Regler, die im Rahmen von Prüfstandsarbeiten oder Prototypen Erprobung eingesetzt werden. Ferner handelt es sich um alle erdenklichen elektrischen, elektronischen und mechatronischen Bauteile, die zur Erprobung oder aber auch zur Evaluierung als Serienbauteile insbesondere in Automotiveanwendungen eingesetzt werden.

Im Rahmen der Erfindung ist es aufgrund der Kommunikation des Mastercontrollers mit den Slavecontrollern über den systemeigenen Bus möglich die zu tauschenden Datenmengen schnell und unkompliziert über die einzelnen Modulebenen zu leiten. Jedes Modul liest dann aus dem systemeigenen Bus wiederum die für das Modul selber bzw. die Einsteckmodule relevanten Daten aus und verwertet diese auf der Modulebene weiter. Der systemeigene Bus kann dabei im Rahmen der Erfindung jedes beliebige Signal sein, mit dem es möglich ist eine Datenweiterleitung für mehrere Teilnehmer zu ermöglichen.

Im Rahmen der Erfindung wird besonders bevorzugt ein SPI-Bus eingesetzt, wobei es sich bei dem SPI-Bus um einen Serial Peripheral Interface handelt. Der SPI-Bus weist einen einfachen Standard für einen synchronen seriellen Datenbus auf, mit dem digitale Schaltungen nach dem Master Slaveprinzip miteinander verbunden werden können.

Bevorzugt weist das Hardwaresystem eine gemeinsame Busleitung auf, die sich insbesondere aus drei gemeinsamen Leitungen zusammensetzt, an denen jeder Teilnehmer, also jede Modulebene angeschlossen ist. Im Rahmen der Erfindung kann das Hardwaresystem jedoch auch mehr oder weniger Leitungen haben, die die einzelnen Modulebenen miteinander verbinden. Vorzugsweise wird ein systemeigener Bus derart gewählt, dass unterschiedliche Taktfrequenzen über den Bus übertragbar sind,so dass der Bus innerhalb unterschiedlicher Taktfrequenzen arbeiten kann. Der systemeigene Bus des erfindungsgemäßen Hardwaresystems zeichnet sich insbesondere dadurch aus, dass er eine große Spannbreite von verschiedenen auch prinzipiell zueinander inkompatiblen Geräten ermöglicht.

Insbesondere bietet der systemeigene Bus des Hardwaresystems, vorzugsweise als serieller Bus, die Möglichkeit die modulare Erweiterungsfähigkeit des Hardwaresystems zu realisieren. Jedes Einsteckmodul besitzt einen Speicherbaustein, auf den die Modulkennung des Einschubmoduls wiederum hinterlegt ist. Bei Programmstart oder aber auch bei Reset des Hardwaresystems fragt der Mastercontroller alle Slavecontroller ab, welche Einsteckmodule potentiell oder aber möglicherweise in das Hardwaresystem eingesteckt sind. Die Slavecontroller haben wiederum auf der Modulebene eines Zwischenmoduls direkten Zugriff auf das Einsteckmodul. Die Istverbauliste der Einsteckmodule wird mit einer im Programmcode hinterlegten Sollverbauliste verglichen und kann somit Abweichungen feststellen. Die Sollverbauliste kann auf Grund der einfachen Bedienbarkeit des Hardwaresystems direkt am Hardwaresystem oder aber über ein externes Kontrollinstrument beispielsweise einen Computer festgelegt, adaptiert oder geändert werden. Der Vergleich der Sollverbauliste mit der Istveblauliste kann auch während des Betriebs des Hardwaresystems manuell oder aber automatisch zyklisch durchgeführt werden, umso zu erkennen, ob Laufzeit Einsteckmodule entfernt bzw. eingesteckt werden oder aber ob Fehler oder Ausfälle an bereits eingesteckten Einsteckmodulen aufgetreten sind. Wird eine Abweichung festgestellt, kann eine entsprechende Fehlermeldung erzeugt werden und/oder der Programmablauf unterbrochen oder aber umgestellt werden.

In einer Grundausführungsvariante des Hardwaresystems ist die Grundplatine in einem Grundmodul angeordnet, wobei in das Grundmobil optional ein Einsteckmodul einsteckbar ist, wobei das Einsteckmodul über den Mastercontroller ansteuerbar ist. Das Hardwaresystem weist somit in einfachster Ausführungsvarainte ein Gehäuse auf, vorzugsweise ein metallisches Gehäuse insbesondere ein leichtmetallisches Gehäuse, in dem eine Grundplatine mit dem Mastercontroller angeordnet ist. In das Gehäuse besteht die Möglichkeit ein Einsteckmodul einzustecken, dass wiederum mit der Grundplatine gekoppelt wird und es somit ermöglicht ein externes Peripheriebauteil, beispielsweise einen Aktor, einen Sensor anzusteuern oder zu regeln bzw. auszulesen oder aber dem Hardwaresystem es ermöglicht mit einem externen Datennetz, beispielsweise einem Kraftfahrzeugbus zu kommunizieren. Das Einsteckmodul ist dann direkt über den Mastercontroller ansteuerbar.

Auf der Modulebene des Grundmoduls kommuniziert der Mastercontroller mit dem in das Grundmodul lösbar eingesteckte Einsteckmodul über den systemeigenen Bus des Hardwaresystems oder der Mastercontroller kommuniziert mit dem Einsteckmodul über einen von dem systemeigenen Bus verschiedenes Datenprotokoll. Hierbei kann es sich dann um ein Datenprotokoll handeln, dass es ermöglicht eine direkte Kommunikation zwischen dem Mastercontroller und dem Einsteckmodul herzustellen. Ebenfalls kann ein zusätzlicher Controller in dem Grundmodul angeordnet sein, der aus dem systemeigenen Bus des gesamten Hardwaresystems die für das Einsteckmodul erforderlichen Daten oder Steuerungssignale ausliest und dann wiederum ebenenintern auf Modulebene des Grundmoduls mit dem Einsteckmodul kommuniziert.

Ein jeweiliges Einsteckmodul des Hardwaresystems, hierbei kann es sich beispielsweise um ein Einsteckmodul in das Grundmodul oder aber auch um ein Einsteckmodul in ein Zwischenmodul handeln, ist mit einem externen Element zum Datenaustausch und/oder elektrisch gekoppelt, wobei das Einsteckmodul und das externe Element das Datenprotokoll des externen Elements zur Kommunikation nutzen. Im Rahmen der Erfindung ist das Einsteckmodul über elektrische Leitungen physisch mit dem externen Element gekoppelt. Hierbei kann es sich beispielsweise um Leistungen zur Stromversorgung oder zum Datenaustausch handeln.

Als externes Element können dann wiederum Stellaktoren an die Einsteckmodule gekoppelt sein, die über einen Treiber der in dem Einsteckmodul platziert ist ansteuerbar sind. Die Steuerungsbefehle erhält das Einsteckmodul jedoch über den systemeigenen Bus von dem Controller der Ebene in der das Einsteckmodul angeordnet ist. Als externes Element kann beispielsweise auch ein Messsensor an das Einsteckmodul angeschlossen sein.

Ebenfalls kann es sich bei dem Einsteckmodul um eine Art Modem handeln, dass es dem Hardwaresystem ermöglicht mit einem externen Datennetz zum Datenaustausch zu kommunizieren. Beispielsweise kann das Einsteckmodul die Fähigkeit besitzen einen kraftfahrzeugeigenen Bus bzw. einen Canbus auszulesen oder aber mit diesen zu kommunizieren. Die entsprechend ausgelesenen Daten gibt das Einsteckmodul dann wiederum über die Modulebene an den Controller weiter, wobei der Controller die Daten über den systemeigenen Bus des Hardwaresystems an den Mastercontroller weitergibt und diese von dort aus weiter verarbeitet werden können. Beispielsweise sind die relevanten Daten dann über ein Display direkt an dem Hardwaresystem anzeigbar, über eine Datenspeichereinheit in dem Hardwaresystem speicherbar oder aber über eine andere oder die gleiche Modulebene des Hardwaresystems an einen externen Computer oder eine externe Auswerteeinrichtung weiterleitbar. Ebenfalls sind auf umgekehrten Wege Daten über das Einsteckmodul in das externe Datennetz einspeisbar, so dass beispielsweise dem Datennetz eine Simulationsumgebung simuliert wird.

Im Rahmen der Erfindung ist bei Anschluss des Einsteckmoduls mit einem externen Element nicht zwingend eine physische Verbindung, beispielsweise in Form eines Netzwerkkabels oder aber in Form von physisch vorhandenen Drahtleitungen zur Übertragung eines Datensignals notwendig, es kann auch eine drahtlose Datenübertragung stattfinden.

Das externe Element und das Einsteckmodul kommunizieren jedoch über das Datenprotokoll des externen Elementes. Gerade hier liegt ein erfindungswesentlicher Vorteil, da die in dem Hardwaresystem selber weitergeleiteten Daten zur Simulation, Auswertung oder Prüfung von an das Hardwaresystem angeschlossenen Peripheriebauteilen auf die notwendigen Daten begrenzbar sind. Auf einer jeweiligen Modulebene bzw. zwischen dem Einsteckmodul und dem an das Einsteckmodul angeschlossenen externen Element können somit die Daten jeweils auf das Wesentliche beschränkt werden, weshalb über dem hardwaresystemeigenen Bus nur von dem jeweiligen Master- oder Slavecontroller gefilterte Daten geleitet werden. Hierdurch wird es ermöglicht eine Vielzahl von verschiedenen Modulebenen an das Hardwaresystem anzuschließen und bis zu mehrere dutzend Einsteckmodule mit jeweils an das Einsteckmodul angeschlossenen externen Elementen, wobei das Hardwaresystem dennoch unter harten echtzeitfähigen Bedingungen arbeiten kann.

Der erfindungsgemäße Aufbau aus modular erweiterbarem Gehäuse sowie der systemeigene Datenaustausch des Hardwaresystems mit einer sehr einfachen modularen Erweiterungsmöglichkeit über die Einsteckmodule bietet erfindungsgemäß insbesondere den Vorteil, dass aufwendige Zeiten zum Aufbau eines Prüfstandes oder einer Simulationsumgebung entfallen. Auf Grund der modulartigen Erweiterbarkeit sowie der einfachen Koppelung der Einsteckmodule mit den jeweiligen Modulebenen des Grundmoduls und oder der Zwischenmodule ist ebenfalls ein fehlerfreier Aufbau möglich, da aufwendige Rüstzeiten für die Verkabelung von Messaufbauten entfallen. Im Falle falschen Anschlusses von physischen Kabelleitungen oder auf Grund von Inkompatibilitäten der einzelnen Hard- und Softwareprodukte von verschiedensten Prüfstandsaufbauten sowie zur Überprüfung, Messung, Regelung oder Steuerung verschiedenster eingesetzter Sensoren oder Aktoren entfallen ebenfalls gänzlich.

Das jeweilige Einsteckmodul dient somit als Schnittstelle zwischen externem Element und dem Hardwaresystem. Es wandelt das externe Datenprotokoll der externen Elemente in ein zumindest ebeneninternes Datenprotokoll der Modulebene beispielsweise des Zwischenmoduls um und kommuniziert mit dem Controller der Modulebene. Im Falle eines Zwischenmodul mit dem Slavecontroller. Somit entsteht auf einer Ebene eines Zwischenmoduls ein ebeneninterner Datentransfer zwischen dem Einsteckmodul und dem Controller des Zwischenmoduls. Hierbei ist es bereits wiederum möglich die nur relevanten Daten des an das Zwischenmodul angeschlossenen externen Elementes an den Controller und somit wiederum über den ebeneninternen Bus des Hardwaresystems an einen Benutzer oder aber an eine Speichereinheit oder Anzeige weiterzugeben. Ebenfalls wird hierüber eine hohe Kompatibilität sichergestellt, da die Treiberhard- und Software zum Betreiben des externen Elementes auf dem Einsteckmodul hinterlegt sind, wobei das Einsteckmodul kompatibel zu dem Hardwaresystem ist.

Hierdurch wird es wiederum ermöglicht, dass nur für den primären Regelungsvorgang und/oder Messvorgang relevante Daten über den systemeigenen Bus ausgetauscht werden. Das System ist somit hart echtzeitfähig, auch bei mehreren Dutzend angeschlossenen Aktoren, Sensoren und/oder bei Auslesen von sogar mehreren verschiedenen externen Datennetzen.

Das erfindungsgemäße Hardwaresystem zeichnet sich weiterhin durch eine Autoadressierungsmöglichkeit aus. Hierbei wird bei Neustart und/oder Reset oder aber bei Einstecken eines neuen Einsteckmoduls und/oder in sich wiederholenden zeitlichen Abständen eine Autoadressierung aller im System angeordneten Modulebenen und/oder Zwischenmodule und/oder Einsteckmodule durchgeführt, bevorzugt ausgehend von dem Grundmodul, insbesondere ausgehend von dem Mastercontroller des Grundmoduls und ganz besonders bevorzugt von dem ersten Einsteckmodul in dem Grundmodul und/oder von dem ersten auf das Grundmodul folgende Einsteckmodul. Bei dem ersten auf das Grundmodul folgenden Einsteckmodul handelt es sich bevorzugt um das Einsteckmodul, dass in dem dem Grundmodul benachbartem Zwischenmodul angeordnet ist. Im Rahmen der Erfindung ist es über den systemeigenen Bus vorstellbar, dass jeweils nur die Master- und Slavecontroller der jeweiligen Modulebenen zueinander autoadressiert sind.

Im Rahmen der Erfindung ist es jedoch auch vorstellbar, dass jedes Einsteckmodul über einen Mikrocontroller verfügt, und sich die einzelnen Mikrocontroller der Einsteckmodule seriell autoadressieren. Hierzu muss jeder Mikrocontroller eine individuelle Nummer besitzen, um im Betrieb des Hardwaresystems individuell ansprechbar zu sein. Mikrocontroller 1 sendet somit ein Resetsignal an den Mikrocontroller 2, welcher sich daraufhin neu bootet. Der Mikrocontrolier 2 sendet ein Resetsignal an Mikrocontroller 3, der sich daraufhin neu bootet und ein Resetsignal an Mikrocontroller 4 sendet, was sich bis zu der Anzahl der angeschlossenen Mikrocontroller an das Hardwaresystem fortsetzt.

Bevorzugt wird bei dem erfindungsgemäßen Hardwaresystem die Autoadressierung derart ausgeführt, dass der erste Mikrocontroller seine Empfängerleitung mit der Senderleitung vertauscht, so dass die Senderleitung zu der Empfängerleitung und die Empfängerleitung zur Senderleitung wird. Auf dieser Leitung wird dann eine Kennung an den zweiten Mikrocontroller gesendet, wobei danach der erste Mikrocontroller seinen ursprünglichen Zustand wiederherstellt. Der zweite Mikrocontroller vertauscht daraufhin wiederum seine Senderleitung mit seiner Empfängerleitung und sendet die Kennung um +1 erhöht an den dritten Mikrocontroller und stellt im Anschluss hieran seinen Ursprungszustand wieder her.

Damit eine serielle Schaltung der einzelnen Mikrocontrollerebenen übergreifend herstellbar ist, ist eine lösbare Steckverbindung der einzelnen Modulebenen untereinander mit einem versetzten Pin gekoppelt. Die Verbindung der Resetleitung der einzelnen Ebenen untereinander weist somit einen Pinversatz auf, so dass die einzelnen Modulebenen faktisch in Reihe geschaltet sind.

Im Rahmen der Erfindung ist dann jedes Einsteckmodul zentral von dem Mastercontroller aus über den systemeigenen Bus ansteuerbar. Ebenfalls ist es im Rahmen der Erfindung möglich das Einsteckmodul dezentral über jeweils einen Slavecontroller aus anzusteuern. Je nach aktueller Betriebsart, auszutauschender Datenmenge und Anforderung an die Echtzeitfähigkeit ist somit eine flexible Regelungs- und Steuerungsmöglichkeit des Hardwaresystems selbst mit einer Vielzahl angeschlossenen externen Elementen möglich. Auch ist ein paralleler Betrieb möglich, wobei der Mastercontroller direkt auf einzelne Einsteckmodule zugreift und andere Einsteckmodule indirekt über die jeweiligen Slavecontroller der Zwischenmodule anspricht.

Weiterhin sind besonders bevorzugt zwei oder mehr Einsteckmodule in einem Zwischenmodul zentral von einem in dem Zwischenmodul befindlichen Slavecontroller aus ansteuerbar. Auch hierdurch wird wiederum eine Filterungsfunktion der jeweiligen auf der Modulebene angeordneten Einsteckmodule vorgenommen. Die auszutauschenden Datenmengen der einzelnen Modulebenen untereinander werden hierdurch reduziert, weshalb es mit dem erfindungsgemäßen Hardwaresystem möglich ist selbst eine Vielzahl von in Reihe geschalteten Zwischenmodulen in harter Echtzeitumgebung zu betreiben.

Weiterhin besonders bevorzugt ist der Slavecontroller als Mikroprozessor ausgebildet, vorzugsweise ist der Slavecontroller durch zwei spiegelsymetrische auf der Zusatzplatine angeordnete Mikroprozessoren ausgebildet. Die Zusatzplatine selber ist dabei als Modulplatine des Zwischenmoduls ausgebildet und weist zusätzliche elektronische Bausteine beispielsweise in Form von Prozessoren oder Speichereinheiten auf. Durch den spiegelsymetrischen Aufbau des Slavecontrollers auf der Zusatzplatine des Zwischenmoduls wird wiederum ein redundanter ebeneninterner Betrieb ermöglicht. Für bestimme insbesondere sicherheitsrelevante Anwendungen kann ein redundanter Betrieb notwendig sein, so dass bei Ausfall eines der zwei spiegelsymetrischen Mikroprozessoren der andere Mikroprozessor die modulebeneninterne Kommunikation und somit die Ansteuerung der in das Modul eingesteckten Einsteckmodule übernimmt.

Zur Autoadressierung selber weist jedes Einsteckmodul einen Speicherbaustein auf, auf dem eine Einsteckmodulkennung gespeichert ist. Vorzugsweise handelt es sich dabei um einen EEPROM.

Im Rahmen der Erfindung ist es möglich, eine Vielzahl verschiedener Einsteckmodule an das erfindungsgemäße Hardwaresystem anzuschließen. So können beispielsweise Einsteckmodule mit Drahtlosdatenübertragungsfunktion angeschlossen werden, sodass das Hardwaresystem in eine Simulationsumgebung bzw. in einen Prüfstandsaufbau eingliederbar ist, ohne physische Verkabelung. Beispielsweise können Drahtlosstandards wie W-Lan, Infrarot, Bluetooth, verschiedene Funkverbindungen oder sonstige Drahtlosübertragungsmöglichkeiten durch geeignete Wahl eines Einsteckmoduls genutzt werden. Im Rahmen der Erfindung ergibt sich hierbei insbesondere der Vorteil, dass die Kompatibilität zwischen dem Funkstandard und dem Hardwaresystem durch das Einsteckmodul gewährleistet wird. So ist das Einsteckmodul mit der Drahtlosdatenübertragungsfunktion kompatibel zu dem Hardwaresystem, indem es bevorzugt autoadressiert direkt ansteuerbar ist und gleichzeitig erfüllt es den Drahtlosdatenübertragungsstandard und kann somit die dort zu übertragenen oder aber zu empfangenen Daten entsprechend verarbeiten.

Ferner kann das Einsteckmodul als Regelelement ausgebildet sein, so dass es beispielsweise Lastströme schalten und/oder regeln kann. Insbesondere bei der Weiterleitung von hohen Lastströmen ist es hier vorteilhaft, wenn von einer externen Stromquelle ein Laststrom von dem Einsteckmodul aus an das externe Element direkt weitergeleitet wird, ohne eine direkte Verbindung mit dem Hardwaresystem. Ausfälle bzw. Beschädigungen des Hardwaresystems aufgrund von Spannungsspitzen werden hierdurch vermieden. Über das Einsteckmodul wird somit lediglich die Regelung der Höhe des Laststroms vorgenommen.

Insbesondere sind auf dem Einsteckmodul dann jeweils ein Treiberelement und/oder eine Treibersoftware für das entsprechend anzuschließende externe Element vorhanden. Dies kann beispielsweise ein Aktor oder aber auch ein Sensor sein bzw. ein Datennetz, mit dem das Einsteckmodul kommunziert. Im Falle eines Datennetzes kommuniziert das Einsteckmodul mit dem Datennetz über den Kommunikationsstandard des Datennetzes selber. Die empfangenen Daten werden von dem Einsteckmodul mindestens auf eine modulebeneninterne Kommunikation gewandelt und von dort aus dann über den systemeigenen Bus des Hardwaresystems an den Mastercontroller oder aber eine externe Datenauswerteeinheit weitergegeben. Im Falle des Sendens von Daten über das Einsteckmodul an das externe Datennetz erfolgt der zuvor beschriebene Weg in umgekehrter Richtung. Weiterhin sind Einsteckmodule mit den in nachfolgender Tabelle dargestellten Funktionen in das erfindungsgemäße Hardwaresystem lösbar einsteckbar.

| **Einschubmodul:** | **Interne Datenkommunikation** | **Ausgangssignal:** | **Bemerkung:** |
|---|---|---|---|
| CAN-Bus High/Lowspeed | Spezifisches SPI-Datenprotokoll | CAN-Bus Datenprotokoll | |
| LIN-Bus 1-fach | Spezifisches RxTx-Datenprotokoll | LIN-Bus Datenprotokoll | Master, Slave, Listener Funktion |
| LIN-Bus 4-fach | Spezifisches RxTx-Datenprotokoll | LIN-Bus (4Stck.) Datenprotokoll | nur Masterfunktion |
| DC-Motortreiber | Spezifische Datensignale | 2 Treiberausgänge (2 Halbbrücken) | |
| Mot-AD | Spezifische Datensignale | 4 Treiberausgänge (4 Halbbrücken) | Zusätzlich 4 AD-Input |
| Schrittmotortreiber | Spezifisches SPI-Datenprotokoll | 4 (bipolar/unipolar) | 1 Schrittmotor pro Modul |
| Analog In | Spezifisches SPI-Datenprotokoll | 8 Eingänge analoge Spannung | |
| Analog Out | Spezifisches SPI-Datenprotokoll | 8 Ausgänge analoge Spannung | |
| Digital In | Spezifische Datensignale | 8 Eingänge digitale Spannung | |
| Digital Out | Spezifische Datensignale | 8 Ausgänge digitale Spannung | |
| USB | Spezifisches RxTx-Datenprotokoll | USB 2.0 Datenprotokoll | |
| RS232/422 | Spezifisches RxTx-Datenprotokoll | Seriell RS232 bzw. 422 Datenprotokoll | |
| Speichermedium SD-Karte | Spezifisches SPI-Datenprotokoll | <kein> | |
| Flex-Ray | Spezifisches SPI-Datenprotokoll | | 1 Flexray Knoten |

Jedes Zwischenmodul und/oder das Deckelmodul wird weiterhin vorzugsweise über das Grundmodul mit einer Grundspannung versorgt, insbesondere über eine zentrale Versorgungsleitung, wobei jedes Modul die Grundspannung auf ihrer Modulebene wiederum unterverteilt.

Die Versorgungsleitung selbst ist dabei in der Modulsteckverbindung integriert oder die Versorgungsleitung ist als separate Versorgungssteckverbindung zwischen den Modulen ausgebildet. Hierüber ist es möglich, die interne Betriebsspannung des Hardwaresystems auf die einzelnen Modulebenen zu verteilen und dort auf die jeweils benötigte Spannung zu transformieren. Das Hardwaresystem ist hierdurch besonders einfach mit einem Aufbau ausgebildet, da eine zentrale Spannungsversorgung jeweils ebenenweise auf die benötigten Ebenenspannungen gewandelt wird.

Weiterhin besonders bevorzugt sind die Modulsteckverbindungen aller Module gleich ausgebildet, so dass bei Austausch und/oder Ergänzung und/oder Entnahme eines Moduls, insbesondere eines Zwischenmoduls die Modulsteckverbindungen der verbleibenden Module wiederum lösbar ineinander steckbar sind. Im Falle eines Hardwaresystems mit mehreren Zwischenmodulen ist es bei Entnahme eines Zwischenmoduls somit in einfacher, schneller und sicherer Weise möglich, die verbleibenden Zwischenmodule wiederum lösbar ineinander zu stecken. Das Hardwaresystem ist sofort danach wieder einsetzbar, ohne das aufwendige neue Verkabelungsarbeiten oder sonstige Anschluss- oder auch Programmierarbeiten durchzuführen sind. Ebenfalls bei Defekt eines Zwischenmoduls ist dieses in besonders einfacher Art und Weise austauschbar oder aber bei beliebiger Erweiterung mit zusätzlichen Zwischenmodulen sind diese in einfacher und schneller Weise an dem Hardwaresystem ergänzbar.

Der Akkumulator selber ist im autarken Betrieb des Hardwaresystems als einzige Spannungsquelle vorgesehen, er kann jedoch auch in Ergänzung zu dem externen Stromnetz, insbesondere bei Spannungsschwankungen und/oder Spannungsausfall redundant eingesetzt werden. Im Rahmen der Erfindung ist es bei Erweiterung des Hardwaresystems um mehr als beispielsweise zwei Dutzend Zwischenmodule möglich, Akkumulatoren in Reihe oder aber parallel für einzelne Zwischenmodule mit anzuschließen, so dass Spannungsschwankungen innerhalb des Hardwaresystems und auch Spannungsschwankungen des Stromnetzes über den oder die Akkumulatoren ausgleichbar sind. Hierzu können die Akkumulatoren über die Einsteckmodule mit dem Hardwaresystem gekoppelt werden oder aber als Zwischenmodul, welches als Akkumulator ausgebildet ist, in dem Hardwaresystem integriert sein.

Weiterhin bevorzugt wird jedes Modul von dem Grundmodul aus mit der Grundspannung versorgt und jedes Zwischenmodul transformiert die Grundspannung auf die jeweils lokal benötigte Spannung. Insbesondere sind dies 3,3 Volt und 5 Volt, da dies Versorgungsspannungen sind, die für viele handelsübliche Messsensoren und Aktuatoren benötigt werden. Ebenfalls ist es möglich, über das Zwischenmodul sowie das Einsteckmodul die Grundspannung direkt weiterzuleiten, so dass ein angeschlossener Aktor direkt über das Hardwaresystem, beispielsweise mit 12 Volt versorgt wird.

Im Rahmen der Erfindung ist es insbesondere möglich, dass das Grundmodul alle anderen Module in einen Sleepmodus schaltet, so dass an diesem keine Spannung anliegt. In der Folge ist das Grundmodul selbst im Sleepmodus noch aktiv. Hierdurch ist es sowohl automatisch als auch manuell möglich, das Hardwaresystem schnell in einen stromsparenden Zustand zu versetzen. Über eine Standby-Funktion des Grundmoduls selber können gewisse Grundaufgaben sowie ein Vorhalten des letzten Softwarebetriebszustandes über das Grundmodul sichergestellt werden, sodass ein schnelles Reaktivieren des Hardwaresystems erreicht wird. Durch diese Funktion eignet sich das erfindungsgemäße Hardwaresystem insbesondere für mobile Ersatzzwecke, da besonders lange Betriebszeiträume durch ein Deaktivieren bei Nichtbenutzung des Hardwaresystems erreicht werden können.

Weiterhin besonders bevorzugt sind über das Grundmodul und/oder ein Zwischenmodul wahlweise und/oder gleichzeitig Arbeitsspannungen oder auch Lastspannungen von im Wesentlichen 3,3 Volt und/oder 5 Volt und/oder 12 Volt an andere Module und/oder Einsteckmodule leitbar. Die Arbeitsspannungen können dann wiederum bevorzugt direkt zur Ansteuerung und/oder zum Betrieb und/oder zum Auslesen von Aktuatoren und/oder Messsensoren und/oder Datennetzen nutzbar sein. Die Arbeitsspannung ist weiterhin bevorzugt direkt als Lastspannung an ein externes Stellelement weiterleitbar. Aktuatoren können im Rahmen der Erfindung beispielsweise ein Scheibenwischermotor, Stellaktuatoren, Servomotoren oder sonstige aktive elektrische, elektronische oder mechatronische Bauteile sein. Datennetze sind im Rahmen der Erfindung insbesondere Datenkommunikationsnetze, beispielsweise in Form eines Bussystems.

Die Lastspannung selber für ein externes Stellelement wird weiterhin bevorzugt von einem externen Stromnetz und/oder einer externen Stromquelle bezogen, wobei diese über das Hardwaresystem steuerbar bzw. schaltbar ist, insbesondere über ein Einsteckmodul. Hierzu weist das Einsteckmodul wiederum besonders bevorzugt ein Potentiometer und/oder ein Leistungstreiber und/oder einen Transformator auf, wobei der Teil des Einsteckmoduls, der die Spannungssteuerung und/oder Spannungstransformation vornimmt, außerhalb des Gehäuses des Hardwaresystems angeordnet ist. Hierdurch erfolgt kein Wärmeeintrag in das Hardwaresystem selber, weshalb auf aufwendige Kühleinrichtungen zum Betrieb des Hardwaresystems, insbesondere zum Dauerbetrieb des Hardwaresystems verzichtet werden kann.

Im Rahmen der Erfindung ist weiterhin mindestens ein Zusatzmodul an dem Hardwaresystem integriert, wobei das Zusatzmodul einen Spannungswandler aufweist, der die Spannung von im Wesentlichen 12 Volt lokal in dem Zusatzmodul in eine dort benötigte Spannung transformiert, vorzugsweise weist jedes Zusatzmodul einen Spannungswandler auf, insbesondere einen getakteten Spannungswandler. Bei dem Zusatzmodul kann es sich im Rahmen der Erfindung um ein Zwischenmodul oder aber auch um ein Einsteckmodul handeln. Durch den Spannungswandler selbst ist es möglich, die Versorgungsspannung des Hardwaresystems von im Wesentlichen 12 Volt, in eine jeweils lokal benötigte Spannung zu transformieren. Bei dem Spannungswandler selber handelt es sich besonders bevorzugt um einen getakteten Spannungswandler, insbesondere einen einstellbaren Spannungswandler, so dass die Spannung über beispielsweise ein Einsteckmodul frei einstellbar ist.

Die Modulsteckverbindungen aller Module, also insbesondere aller Zwischenmodule, sind gleich, so dass bei Austausch und/oder Ergänzung und/oder Entnahme eines Moduls, insbesondere eines Zwischenmoduls, die Modulsteckverbindungen der verbleibenden Module wiederum in einfacher Weise lösbar ineinander steckbar sind. Somit können bei einem bereits in einer Umgebung implementierten Hardwaresystem in einfacher Art und Weise weitere Zwischenmodule ergänzt oder aber Zwischenmodule entfernt werden. Durch einfaches wiederum lösbares Ineinanderstecken der verbleibenden Module ist das Hardwaresystem sofort wieder einsatzfähig. Auch hier entfallen aufwendige Anschluss- oder Umbauarbeiten, insbesondere aufwendige Verkabelungsarbeiten. Durch wiederum einfaches Einstecken der Einsteckmodule in das Gehäuse des Hardwaresystems können verschiedenste Peripheriebauteile bzw. Sensoren oder Aktoren wiederum betriebssicher an das Hardewaresystem gekoppelt werden.

Die vorliegende Erfindung zeichnet sich weiterhin dadurch aus, dass das Hardwaresystem zur Erprobung von Prototypenfahrzeugen verwendet wird. Insbesondere durch die modulare Konfiguration und die lösbaren Einsteckmodule in Verbindung mit den besonders kleinen Abmessungen von wenigen Dezimetern des Gesamtsystems, eignet sich das Hardwaresystem zum Einsatz in Kraftfahrzeugen, bei denen nur ein geringer Platz für Prüfstandsequipment vorhanden ist. Das Hardwaresystem lässt sich problemlos beispielsweise auch in kleinen Einbaunischen unterbringen, beispielsweise in einem Handschuhfach oder hinter einer Seitenverkleidung. Das geringe Gewicht des Hardwaresystems sowie die geringen Abmessungen beeinflussen somit in zu vernachlässigendem Umfang die Realerprobung des Kraftfahrzeuges. Ebenfalls durch den einfachen modularen Aufbau sowie die Möglichkeit der mobilen Anwendung des Betreibens des Hardwaresystems über einen Akkumulator oder aber über das Kraftfahrzeugbordnetz, wird die erfindungsgemäße Verwendugsmöglichkeit im mobilen Einsatz begünstigt.

Das Hardwaresystem kann weiterhin als Gateway zwischen verschiedenen Bussystemen genutzt werden. Das Hardwaresystem erfüllt somit eine Modemfunktion, indem es als Schnittstelle zwischen verschiedenen Datenübertragungsstandards dient. Dies kann beispielsweise bei der Erprobung eines Kraftfahrzeuges dann sinnvoll sein, wenn auf ein vorhandenes Kraftfahrzeugsystem neue Systemkomponenten appliziert werden müssen, beispielsweise ein neues Navigationssystem oder aber eine neue Regelungselektronik für verschiedene Fahrerassistens- oder Komfortsysteme, die bisher noch nicht den Datenkommunikationsstandard des Kraftfahrzeugs erfüllen. Das Hardwaresystem kann aufgrund seiner harten Echtzeitfähigkeit somit als Schnittstelle dienen, um zunächst erste Testphasen zu überbrücken. Ebenfalls ist es mit dem erfindungsgemäßen Hardwaresystem somit möglich, von Datenübertragunsstandards über Leitungen auf Drahtlosdatenübertragungsstandards zu übersetzen.

Als weitere Verwendungsmöglichkeiten in Prototypenfahrzeugen ist es möglich, verschiedene CAN-Signale zwischen unterschiedlichen Bussystemen in Echtzeit zu übertragen oder aber Bussignale selbst zu simmulieren. Ebenfalls kann das Hardwaresystem ein vernetztes Steuergerät simmulieren oder aber auch eine Messdatenerfassung bewerkstelligen. Darüber hinaus ist die Steuerung und Regelung von externen Komponenten, beispielsweise Sensoren, Stellmotoren oder Ähnlichem per Spannungssignal, sowohl analog als auch digital, möglich.

Weitere Verwendungsmöglichkeit für das erfindungsgemäße Hardwaresystem ist als Handheld-Gerät zum Prüfen und Ansteuern von Bauteilkomponenten. Ebenfalls ist das Hardwaresystem als zentrales Steuergerät für Prüfstände oder Prüfvorrichtungen von kleinen Elektronikprüfständen bishin zu Motorprüfständen verwendbar. Ebenfalls kann das Hardwaresystem über eine entsprechende PC-Software konfiguriert werden und ist aufgrund verschiedener Einsteckmodule mit einer Vielzahl von am Markt erhältlichen Simulationssoftwaren kompatibel. Beispielsweise kann Matlab Simulink mit Mikro-Autobox auf dem Hardwaresystem implementiert werden.

Weiterhin eignet sich das Hardwaresystem als Kleinseriensteuergerät für Sonderfahrzeuge. Hier können verschiedene Regelungs- und Steuerungsaufgaben über das erfindungsgemäße Hardwaresystem vorgenommen werden.

Die zuvor genannten Eigenschaften bzw. Merkmale sind im Rahmen der Erfindung beliebig untereinander kombinierbar mit den sich damit ergebenden Vorteilen, ohne den Rahmen der Erfindung zu verlassen.

Weitere Vorteile, Merkmale, Eigenschaften und Aspekte der vorliegenden Erfindung sind Bestandteil der folgenden Beschreibung. Bevorzugte Ausführungsvarianten werden in den schematischen Figuren dargestellt. Diese dienen dem einfachen Verständnis der Erfindung. Es zeigen:
- Figur 1: ein erfindungsgemäßes Hardwaresystem mit Zwischenmodul in Explosivdarstellung;
- Figur 2a und b: das Hardwaresystem in Zusammenbauweise;
- Figur 3a bis d: das Deckelmodul in verschiedenen Ansichten;
- Figur 4a bis d: das Zwischenmodul in verschiedenen Ansichten;
- Figur 5a bis d: das Grundmodul in verschiedenen Ansichten;
- Figur 6a und b: die Zwischenschicht in verschiedenen Ansichten;
- Figur 7a bis d: das Einsteckmodul in verschiedenen Ansichten;
- Figur 8: die zentrale Spannungsversorgung;
- Figur 9: eine Spannungsverteilung in einem Zwischenmodul;
- Figur 10: eine Datenkommunikation zwischen einem Modul, Einsteckmodul und einem an das Einsteckmodul angeschlossenen externen Element;
- Figur 11: einen spiegelsymmetrischen Aufbau eines Zwischenmoduls mit vier Einsteckmodulen;
- Figur 12: ein Schema der Autoadressierung;
- Figur 13: eine schematische Darstellung des Pfostenfeldsteckers der einzelnen Modulebenen;
- Figur 14: eine Autoadressierung auf einer Modulebene und
- Figur 15: eine Elektronikplatine zur Anordnung in einem erfindungsgemäßen Gehäuse.

In den Figuren werden für gleiche oder ähnliche Bauteile aus Vereinfachungsgründen dieselben Bezugszeichen verwendet, auch wenn eine wiederholte Beschreibung aus Vereinfachungsgründen entfällt.

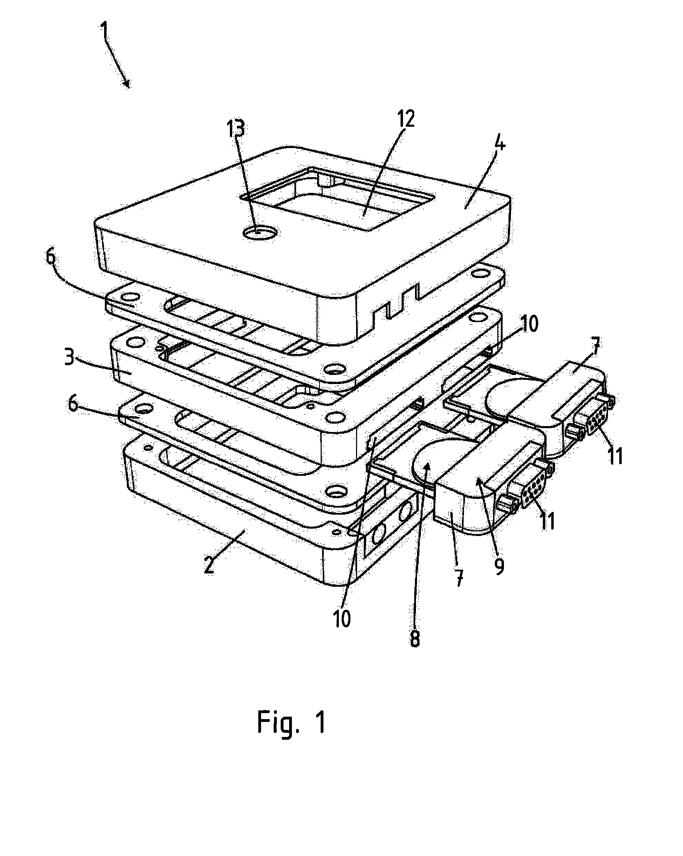

Figur 1 zeigt das erfindungsgemäße modular konfigurierbare Hardwaresystem 1 in einer Explosivdarstellung. Das Hardwaresystem 1 weist ein Grundmodul 2, ein Zwischenmodul 3 sowie ein Deckelmodul 4 auf. Im Rahmen der Erfindung ist es möglich, zwei, drei, vier oder aber beliebig viele, technisch sinnvolle, Zwischenmodule 3 zwischen dem Grundmodul 2 und dem Deckelmodul 4 anzuordnen. So ist es beispielsweise im Rahmen der Erfindung möglich, bis zu 50 oder sogar 60 Zwischenmodule 3 zwischen Grundmodul 2 und Deckelmodul 4 anzuordnen. In der Regel sollten als Haupteinsatzzweck zwischen zwei und elf Zwischenmodule 3 zwischen dem Grundmodul 2 und dem Deckelmodul 4 angeordnet werden. Die einzelnen Module 2, 3, 4 bilden dabei jeweils eine Modulebene 5. Die einzelnen Modulebenen 5 sind untereinander von einer jeweiligen Zwischenschicht 6 getrennt. Bei der Zwischenschicht 6 kann es sich dabei um eine Isolierungsschicht oder aber auch eine Zwischenschicht 6 aus einem metallischen Material handeln.

In das Hardwaresystem 1 sind weiterhin Einsteckmodule 7 lösbar einsteckbar. Die Einsteckmodule 7 weisen selber wiederum einen Kartenabschnitt 8 sowie einen Modulabschnitt 9 auf. Der Kartenabschnitt 8 ist dabei vollständig in eine Einstecköffnung 10 des Hardwaresystems 1, hier dargestellt in eine Einstecköffnung 10 des Zwischenmoduls 3, einsteckbar. Der Modulabschnitt 9 des Einsteckmoduls 7 steht dann gegenüber dem Hardwaresystem 1 über. Jedes Einsteckmodul 7 weist wiederum einen Stecker 11 auf, an dem dann, hier nicht näher dargestellte Sensoren, Aktoren oder aber auch Datennetze ansteckbar sind.

Das Deckelmodul 4 des Hardwaresystems 1 weist ferner ein Display 12 auf, über das Bestdatenbetriebszustände oder sonstige Informationen anzeigbar sind. Ferner ist das Display 12 als Touchdisplay ausgebildet, so dass sich das Hardwaresystem 1 auch über das Display 12 selbst bedienen lässt. In dem Deckelmodul 4 ist weiterhin ein zentraler Taster 13 angeordnet, dessen Funktion im Rahmen der Erfindung wiederum frei programmierbar ist. Es bietet sich an, den zentralen Taster 13 für einen Powerdownmodus, also einen Taster 13, um das Hardwaresystem, 1 in einen Bereitschaftszustand oder aber in einen Sleepzustand zu versetzen.

Nachfolgende Figuren sind nicht maßstabsgetreu. Das Hardwaresystem kann quadratisch oder auch rechteckförmig konfiguriert sein.

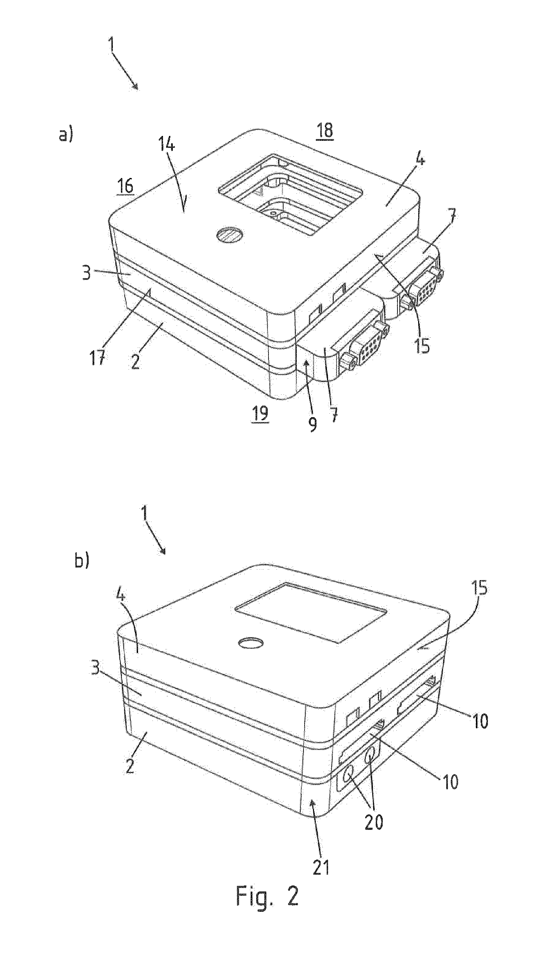

Figur 2a und b zeigen das erfindungsgemäße Hardwaresystem 1 in Zusammenbauweise, ebenfalls bestehend aus einem Grundmodul 2, Zwischenmodul 3 sowie einem Deckelmodul 4. Zwischen den einzelnen Modulen sind wiederum Zwischenschichten 6 angeordnet, die eine Trennung der Modulebenen 5 untereinander ermöglichen. Gut zu erkennen ist, dass das Hardwaresystem 1 eine kastenförmige Konfiguration aufweist. Die Oberseite 14 wird dabei von dem Deckelmodul 4 gebildet. Ebenfalls in Figur 2a ist dargestellt, dass die Einsteckmodule 7 in das Zwischenmodul 3 an einer vorderen Einsteckseite 15 nebeneinander eingesteckt sind. An einer nicht näher dargestellten hinteren Einsteckseite 16 ist es ebenfalls möglich, zwei Einsteckmodule 7 in das Zwischenmodul 3 einzustecken. Demgegenüber verbleiben eine auf die Bildebene bezogene vordere Seitenwand 17 sowie eine hintere Seitenwand 18. Die Seitenwände 17, 18 selber sowie die Einsteckseiten 15, 16 bilden dabei die seitlichen Wände des Gehäuses. Die Oberseite 14 wird durch das Deckelmodul 4 mit ausgebildet sowie die nicht näher dargestellte Unterseite 19 durch das Grundmodul 2. Die Einsteckmodule 7 selbst kommen dabei mit dem Modulabschnitt 9 an der vorderen Einsteckseite15 zur Anlage. Der Modulabschnitt 9 selber steht gegenüber der vorderen Einsteckseite 15 über. Das Hardwaresystem in Figur 2a ist ohne elektronisches Innenleben, also nur als leeres Gehäuse dargestellt.

In Figur 2b dargestellt ist das zusammengebaute Hardwaresystem 1 ohne Einsteckmodule 7. Zu erkennen sind die zwei Einsteckschächte 10 in der vorderen Einsteckseite 15 auf Höhe des Zwischenmoduls 3. Ebenfalls zu erkennen ist ein Spannungsanschluss 20 in dem Grundmodul 2 zum Anschluss von hier nicht näher dargestellten Spannungsversorgungsleitungen. Ferner weist die kastenförmige Gehäusekonfiguration abgerundete Ecken 21 auf, die einen Übergang von der vorderen Einsteckseite 15 zu der hinteren Seitenwand 18 und von der hinteren Seitenwand 18 zu der hinteren Einsteckseite 16 ermöglichen. Hierdurch wird die Handhabung des Hardwaresystems 1 vereinfacht sowie das Verletzungsrisiko eines Bedieners verringert.

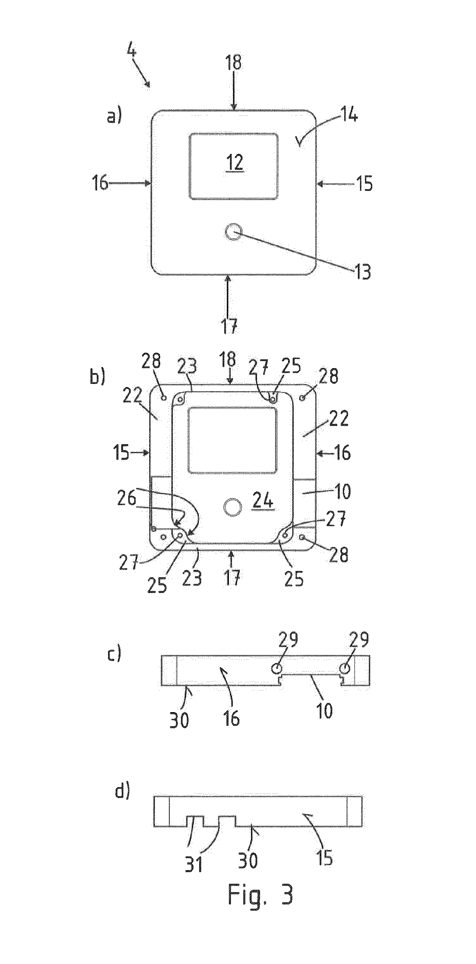

Figur 3a bis d zeigen ein Deckelmodul 4 in einer Draufsicht, Unteransicht sowie einer jeweiligen Seitenansicht der vorderen 15 und hinteren Einsteckseite 16. In Figur 3a ist eine Draufsicht auf die Oberseite 14 des Deckelmoduls 4 gezeigt. Das Deckelmodul 4 weist eine im Wesentlichen quadratische Konfiguration auf, wobei in die Oberseite 14 das Display 12 sowie ein Taster 13 eingelassen sind.

In Figur 3b ist dargestellt, dass an der vorderen Einsteckseite 15 sowie an der hinteren Einsteckseite 16 eine jeweils dickere Gehäusewandung 22 ausgebildet ist, in Relation zu der Gehäusewandung 23 der vorderen 17 und hinteren Seitenwand 18. Im Inneren des Deckelmoduls 4 ist eine Ausnehmung 24 ausgebildet, sodass das Deckelmodul 4 von innen hohl ist. Es ist somit möglich, eine nicht näher dargestellte Platine in dem Deckelmodul 4 mit entsprechend auf der Platine angeordneten Elektronikkomponenten zu platzieren.

Weiterhin sind in der Ausnehmung 24 Montagesockel 25 vorhanden, wobei die Montagesockel 25 dazu dienen, die nicht näher dargestellte Platine aufzunehmen. Die dargestellten Rundungen 26 bzw. Radien entstehen durch eine Herstellung des Deckelmoduls 4 in Fräsbauweise. Hierdurch wird es ermöglicht, den zur Verfügung stehenden Bauraum optimal auszunutzen, bei gleichzeitiger günstiger Herstellung durch Verwendung entsprechender spanabhebender Fräsmittel. In den Montagesockeln 25 sind Montagelöcher 27 angeordnet, so dass die nicht näher dargestellte Platine in den Montagelöchern 27 steckbar und/oder schraubbar ist. Ferner sind in den Gehäusewandungen 22, 23 ebenfalls Montagelöcher 28 angeordnet, mit denen es möglich ist, die einzelnen Modulebenen 5 miteinander zu koppeln.

Figur 3c zeigt eine Ansicht der hinteren Einsteckseite 16, wobei, wie hier dargestellt, ein Einsteckschacht in dem Deckelmodul 4 angeordnet ist. Auf die Bildebene bezogen oberhalb des Einsteckschachtes 10 sind Magnete 29 angeordnet, wobei die Magnete 29 dazu dienen, mit dem hier nicht näher dargestellten Magneten eines Einsteckmoduls 7 eine formschlüssige magnetische Verbindung herzustellen. Hierdurch wird sichergestellt, dass das Einsteckmodul 7 lösbar ordnungsgemäß in den Einsteckschacht eingesteckt wird und durch die magnetische Verbindung gehalten wird und das beim Einstecken entstehende Klackgeräusch dem Bediener dieses auch zu erkennen gibt. Das eingesteckte Einsteckmodul 7 wird durch die magnetische Verbindung arretiert, so dass es nicht unbeabsichtigt bzw. ungewollt aus dem Gehäuse entfernt wird bzw. aus diesem herausfällt.

Ferner ist der Einsteckschacht 10 durchgängig auf die Oberfläche der Montageunterseite 30 des Deckelmoduls 4 ausgebildet. Dies bedingt eine besonders kostengünstige Fertigungsmöglichkeit, da mit einem spanabhebenden Fräswerkzeug direkt der Einsteckschacht 10 mit ausgebildet werden kann.

Figur 3d zeigt die vordere Einsteckseite 15 des Deckelmoduls 4, wobei hier zwei Stecköffnungen 31 angeordnet sind, wobei nur die Stecköffnungen 31 weitere, nicht näher dargestellte oder beschriebene Steckverbindungen einsteckbar sind.

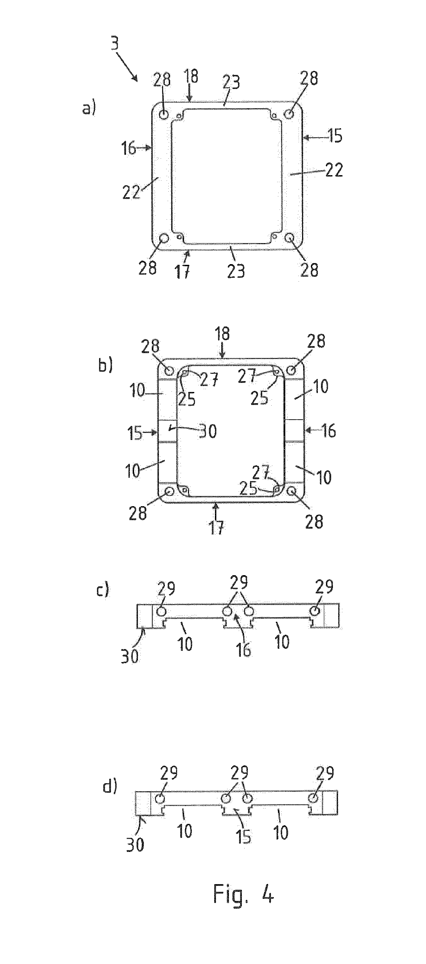

Figur 4a bis d zeigen weiterhin eine Draufsicht, eine Hinteransicht sowie jeweils eine Seitenansicht der vorderen Einsteckseite 15 und der hinteren Einsteckseite 16 eines Zwischenmoduls 3. Auch bei dem Zwischenmodul 3 ist gemäß Figur 4a und b zu erkennen, dass die Gehäusewandung 22 der vorderen Einsteckseite 15 und der hinteren Einsteckseite 16 größer ausgebildet ist, als die Gehäusewandung 23 der vorderen Seitenwand 17 und der hinteren Seitenwand 18. Insbesondere im Bereich der Einsteckschächte 10 bietet die breitere Gehäusewandung 22 der vorderen Einsteckseite 15 sowie der hinteren Einsteckseite 16 eine bessere Abstützmöglichkeit für die hier nicht näher dargestellten Einsteckmodule 7. Der nicht näher dargestellte Kartenabschnitt 8 des Einsteckmoduls 7 wird durch die breite Gehäusewand 22 der vorderen Einsteckseite 15 und/oder der hinteren Einsteckseite 16 abgestützt.

Das Zwischenmodul 3 ist im Inneren vollständig ausgehüllt. Auch hier kann wiederum eine nicht näher dargestellte Elektronikplatine angeordnet werden. Dazu weist das Zwischenmodul 3 ebenfalls Montagesockel 25 auf, wobei die Montagesockel 25 ebenfalls Montagelöcher 27 aufweisen, um die nicht näher dargestellte Elektronikplatine festzuschrauben. Weiterhin sind Montagelöcher 28 in den Ecken der Gehäusewandungen 22, 23 dargestellt, so dass mehrere Zwischenmodule 3 bzw. das Deckelmodul 4 und/oder das Grundmodul 2 an dem Zwischenmodul 3 steckbar und/oder verschraubbar sind.

Weiterhin ersichtlich ist in Figur 4c und d, die jeweils die vordere Einsteckseite 15 bzw. hintere Einsteckseite 16 darstellen, dass das Zwischenmodul 3 spiegelsymmetrisch aufgebaut ist. Hierdurch wird es ermöglicht, vier Einsteckmodule 7 in ein Zwischenmodul 3 einzustecken. Auch sind die Einsteckschächte 10 in dem Zwischenmodul 3 derart ausgebildet, dass sie in eine Montageunterseite 30 des Zwischenmoduls 3 übergehen. Auch hierdurch ergibt sich wiederum der Vorteil einer besonders kostengünstigen Fertigung. Auch sind an der vorderen Einsteckseite 15 und an der hinteren Einsteckseite 16 Magnete 29 angeordnet, wobei die Magnete 29 wiederum mit an den hier nicht näher dargestellten Einsteckmodulen 7 angeordneten Magneten eine formschlüssige magnetische Verbindung eingehen.

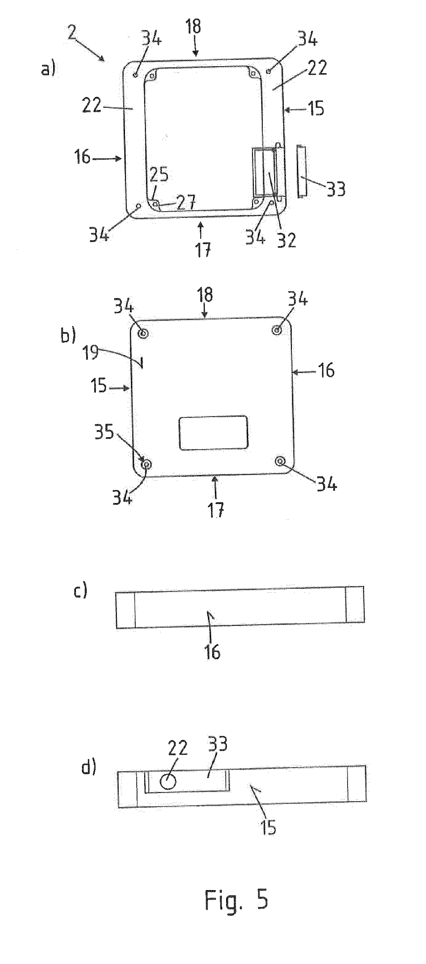

Weiterhin dargestellt sind in Figur 5a bis d eine Draufsicht, eine Unteransicht sowie eine Ansicht der vorderen Einsteckseite 15 und der hinteren Einsteckseite 16 des Grundmoduls 2.

Figur 5a zeigt eine Draufsicht auf das Grundmodul 2, wobei auch hier die Gehäusewandung 22 der vorderen Einsteckseite 15 und der hinteren Einsteckseite 16 gegenüber der Gehäusewandung 23 der vorderen Seitenwand 17 und der hinteren Seitenwand 18 dicker ausgebildet ist. Weiterhin dargestellt ist eine Öffnung 32 für den Spannungsanschluss 20, wobei in die Öffnung 32 ein Adapterstück 33 einsetzbar ist. Das Grundmodul 2 weist die Unterseite 19 des Hardwaresystems 1 gemäß Figur 5b auf. Eingezeichnet sind hier vier Schraubverbindungen 34, die es ermöglichen, das gesamte Hardwaresystem 1 miteinander zu koppeln. Ebenfalls kann im Bereich der Schraubverbindung 34 jeweils ein Fuß 35 angeordnet sein, welcher beispielsweise ein Gummifuß sein kann, sodass das Hardwaresystem 1 sicher und rutschfest auf einen Untergrund stellbar ist. Weiterhin sind in Figur 5a ebenfalls Montagesockel 25 zur Anordnung eine nicht näher dargestellten Grundplatine im Inneren des Grundmoduls vorgesehen. Auch die Montagesockel 25 weisen wiederum Montagelöcher 25 zur Kopplung der Grundplatine mit dem Grundmodul 2 auf. Die Grundplatine kann im Rahmen der Erfindung auch in dem Deckelmodul 4 angeordnet werden, so dass durch das Grundmodul 2 eine Spannungsversorgung des Hardwaresystems 1 hergestellt wird.

Figur 5c und d zeigen jeweils eine Seitenansicht, wobei in Figur 5d eine Seitenansicht der vorderen Einsteckseite 15 und der hinteren Einsteckseite 16, in Figur 5c gezeigt ist. In Figur 5d ist das Adapterstück 33 in der Öffnung 20 angeordnet ist und das Adapterstück 33 weist einen Spannungsanschluss 20 auf. In der Regel sind dies 12 Volt.

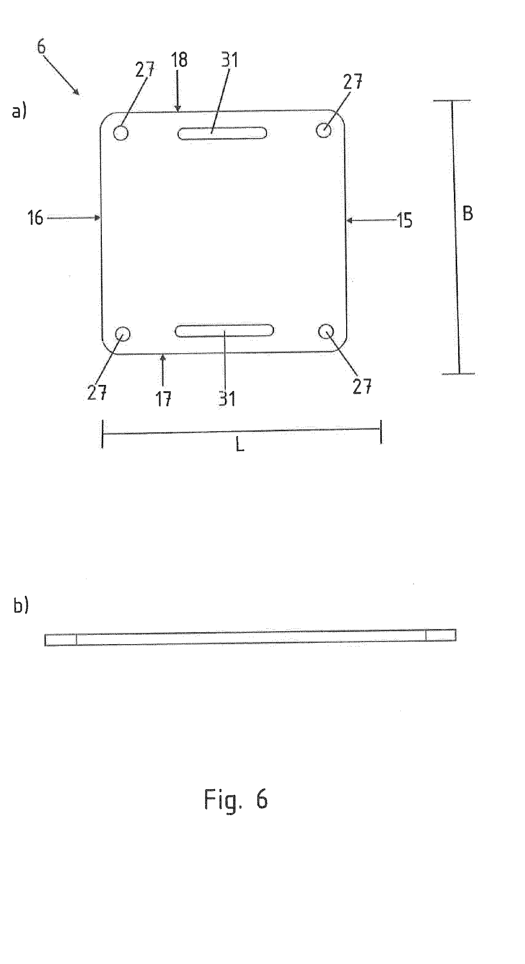

In Figur 6a und b ist eine Zwischenschicht 6 in einer Draufsicht sowie in einer Seitenansicht gezeigt. Die Zwischenschicht 6 dient als Isolator und/oder Abstandhalter zwischen den einzustellenden Modulen. Auch die Zwischenschicht 6 weist Montagelöcher 27 zur Durchführung hier nicht näher dargestellter Montagemittel, die zur Kopplung der einzelnen Module eingesetzt werden, auf. In der hier gezeigten Ausführungsvariante ist die Zwischenschicht 6 massiv ausgebildet, d. h. sie schottet die einzelnen Modulebenen 5 voneinander physisch ab.

Damit die Platinen der jeweiligen Module miteinander kommunizieren können, sowie mit Strom versorgt werden, weist die Zwischenschicht 6 Steckeröffnungen 31 auf, wobei durch die Steckeröffnungen 31 mehrpolige Pfostenfeldstecker 65 zum Datenaustausch und/oder zur Spannungsversorgung der einzelnen Platinen der Module ausgebildet sind. Die Steckeröffnungen 31 sind dabei im Bereich der Gehäusewandung 23 der vorderen Seitenwand 17 sowie der hinteren Seitwand 18 angeordnet. Die hier nicht näher dargestellten Pfostenfeldstecker 65 ermöglichen es also, die Einsteckmodule 7 mit dem Kartenabschnitt jeweils vollständig in das Modul einzuführen und somit an den nicht näher dargestellten Pfostenfeldsteckern 65 vorbeizuführen. Die Zwischenschicht 6 ist in ihrer Länge L und Breite B den einzelnen Modulen der Figuren 3, 4 und 5 entsprechend ausgebildet. Insbesondere in der Länge L ist es jedoch möglich, dass die Zwischenschicht 6 gegenüber den Modulen übersteht, so dass sie auch den Modulabschnitt des Einsteckmoduls 7 zumindest teilweise überdeckt.

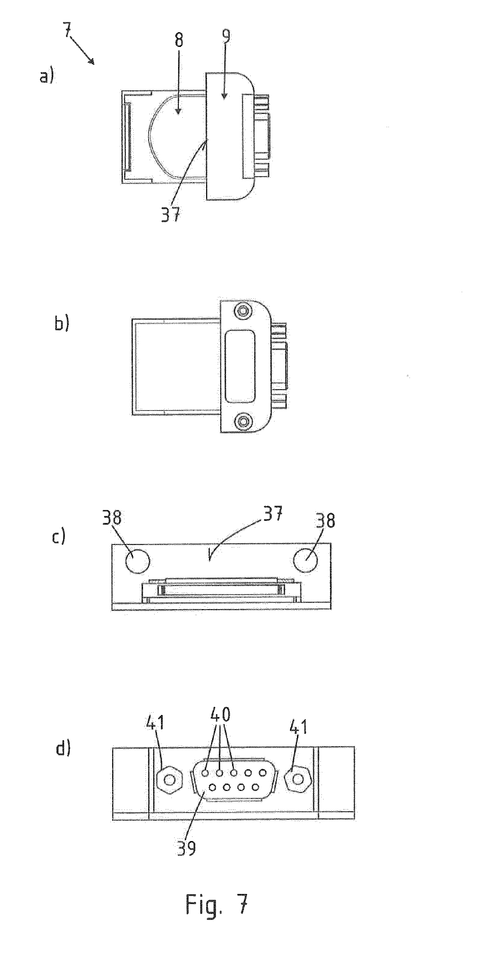

Figur 7a bis d zeigen ein Einsteckmodul 7 in einer Draufsicht, in einer Unteransicht sowie in einer Vorder- und einer Rückansicht. In Figur 7a und b ist die Einteilung des Einsteckmoduls 7 ein Kartenabschnitt 8 und Modulabschnitt 9 zu erkennen. Der Kartenabschnitt 8 wird dabei vollständig in das nicht näher dargestellte Hardwaresystem 1 eingesteckt, so dass der Modulabschnitt 9 formschlüssig mit einer Anlagefläche 37 an der vorderen 15 bzw. hinteren Einsteckseite 16 des Hardwaresystems 1 zur Anlage kommt.

Im Modulabschnitt 9 selber ist dann eine entsprechende Hardware für den Anschluss eines nicht näher dargestellten externen Elements, beispielsweise eines Senors oder aber auch eines Aktors unterbringbar. Hierdurch ergibt sich erfindungsgemäß der Vorteil, dass ein Wärmeeintrag in das Hardwaresystem 1 selber vermieden wird, da die elektrischen Bauteile außerhalb des Hardwaresystemsm 1 selber untergebracht sind.

In Figur 7c ist dargestellt, dass der Modulabschnitt mit einer Anlagefläche 37 an dem Hardwaresystem 1, genauer an der vorderen Einsteckseite 15 oder an der hinteren Einsteckseite 16 zur Anlage kommt. In die Anlagefläche 37 eingelassen sind Einsteckmodulmagneten 38, die mit dem Magneten 29 des Hardwaresystems 1 eine magnetische Verbindung eingehen und somit ein vollständiges Einrasten sowie einen festen Sitz der Einsteckmodule 7 in dem Hardwaresystem 1 sicherstellen.

In Figur 7d ist eine mögliche Anschlussmöglichkeit eines nicht näher dargestellten Sensors, Aktors oder Ähnlichem an das Einsteckmodul 7 in Form eines D-Sub-Steckers 39 dargestellt. Der D-Sub-Stecker 39 selber besteht dabei aus neun Polen 40 sowie zwei Sicherungsschrauben 41. Im Rahmen der Erfindung ist es aber beispielsweise auch vorstellbar, andere Steckverbindungen einzusetzen, beispielsweise Ethernetsteckverbindungen oder aber auch nur einen zweipoligen Stecker.

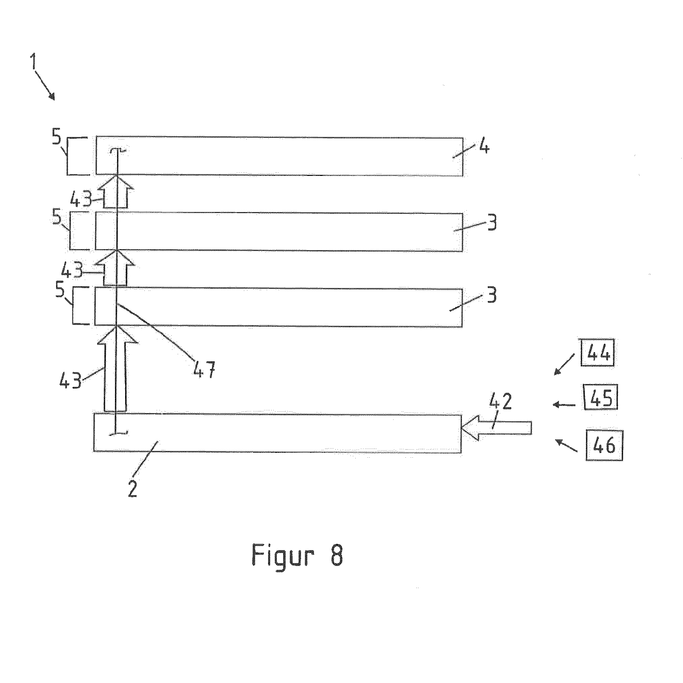

Figur 8 zeigt die Spannungsversorgung des Hardwaresystems 1, wobei hier dargestellt eine externe Versorgungsspannung 42 in das Grundmodul 2 beigebracht wird, und die externe Versorgungsspannung 42 von dem Grundmodul 2 aus auf die einzelnen Modulebenen 5 weitergeleitet wird. Die externe Versorgungsspannung 42 wird also von dem Grundmodul 2 als interne Versorgungsspannung 43 direkt weitergeleitet. Bevorzugt ist die externe Versorgungsspannung 42 gleich der internen Versorgungsspannung 43 gleich im Wesentlichen 12 Volt. Der Aufbau des Hardwaresystems 1 kann in der in Figur 8 dargestellten Konfiguration derart ausgebildet sein, dass das Deckelmodul 4 als Master fungiert und die Zwischenmodule 3 als Slave. Das Grundmodul 2 hat dann eine ausschließlich abschließende Funktion des Gehäuses sowie eine Weiterleitung der Versorgungsspannung 42.

Die Versorgungsspannung selber kann von einem Netzteil 44, von einem Akkumulator 45 oder aber auch von einem Kraftfahrzeugbordnetz 46 in das Grundmodul 2 eingespeist werden. Ebenfalls ist es vorstellbar, dass das Grundmodul 2 selber als Akkumulator 45 ausgebildet ist, also im Inneren des Grundmoduls 2 ein entsprechender Akkumulator 45 bzw. Akkumulatorzellen angeordnet sind. Im Rahmen der Erfindung verfügt das Hardwaresystem 1 über eine modular erweiterbare, physisch direkt gekoppelte Versorgungsleitung 47, die durch das gesamte Hardwaresystem 1 ausgebildet ist. Die Versorgungsleitung 47 ist mindesten einadrig, bevorzugt zwei- oder aber auch dreiadrig ausgebildet. Ebenfalls ist es im Rahmen der Erfindung vorstellbar, die Versorgungsleitung 47 redundant spiegelsymmetrisch bzw. mit einem nicht näher dargestellten Pfostenfeldstecker 65 ebenfalls redundant auszubilden. Das Hardwaresystem 1 verfügt somit über eine zentrale Spannungsversorgung.

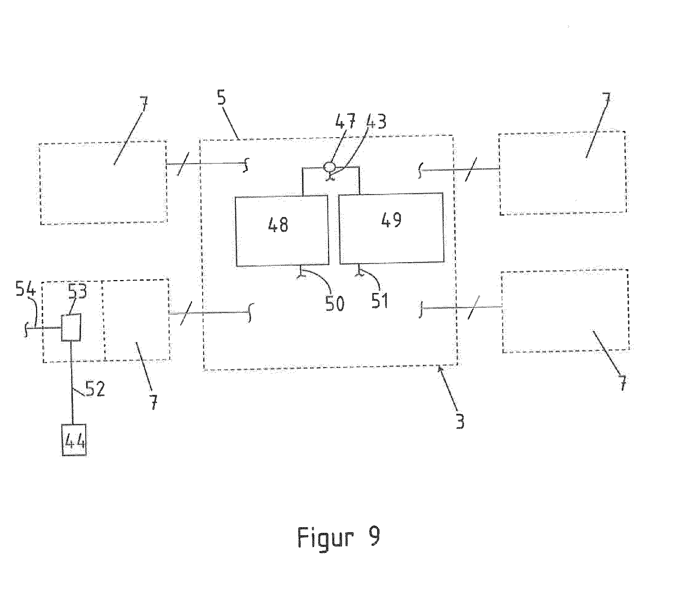

Figur 9 zeigt die Spannungsverteilung in einem Zwischenmodul 3. Hier ist zum einen die interne Versorgungsspannung 43 direkt von der Versorgungsleitung 47 abgreifbar und auf dem Modul direkt als interne Versorgungsspannung 43 weiterleitbar. Die interne Versorgungsspannung 43 ist jedoch auch im Rahmen der Erfindung von der Versorgungsleitung 47 abgreifbar und an einen jeweiligen Spannungswandler weiterleitbar. Hier dargestellt sind bevorzugt ein Spannungswandler 48, der eine Spannung 50 von 5 Volt und ein Spannungswandler 49, der eine Spannung 51 von 3,3 Volt wandelt. Von den Spannungswandlern 48, 49 sind dann Modulebenenspannungen in Höhe von 5 Volt 50 und Modulebenenspannungen in Höhe von 3,3 Volt 51 abgreifbar. Die drei verschiedenen Spannungsarten, also die interne Versorgungsspannung 43, die Modulebenenspannungen 5 Volt 50 und die Modulebenenspannungen 3,3 Volt 51 sind dann von jedem Einsteckmodul 7 auf der Modulebene 5 abgreifbar bzw. an das jeweilige Einsteckmodul 7 weiterleitbar. Bei den Spannungswandlern 48,49 handelt es sich bevorzugt um getaktete Spannungsregler, um den Wärmeeintrag in dem System auch bei hoher Anzahl von Modulebenen 5 so gering wie möglich zu halten. Die Spannungswandler 48, 49 sind derart ausgelegt, dass sie eine Modulebene 5 mit vier Einsteckmodulen 7 und ausreichender Reserve mit der benötigten Spannung versorgen können.

Im Rahmen der Erfindung ist es weiterhin vorstellbar, dass insbesondere höhere Lastströme 54 geschaltet werden müssen. Bei Aktoren, die selbst nicht von einer externen Spannungsquelle, sondern von der Regelungs- bzw. Steuerungseinheit mit Spannung versorgt wird, ist dies insbesondere erforderlich. Hierbei wird wiederum von einem entsprechenden Netzteil 44, welches das gleiche Netzteil 44 der Versorgungsspannung 43 des Hardwaresystems 1 oder aber auch ein hiervon verschiedenes Netzteil sein kann, eine Lastversorgungsspannung 52 abgreifbar, die dann durch einen Leistungstreiber 53 derart geregelt wird, dass ein Laststrom 54 an ein hier nicht näher dargestelltes externes Element 58, beispielsweise einen Motortreiber, weitergegeben wird. Da sich der Leistungstreiber 53 selbst wiederum nicht innerhalb des Hardwaresystems 1 befindet, sondern bevorzugt in dem Einsteckmodul 7, erfolgt somit auch kein Wärmeeintrag in das Hardwaresystem 1 selber.

Durch die in Figur 8 und Figur 9 gezeigte zentrale Spannungsversorgung ist es somit möglich, eine zentrale interne Versorgungsspannung 43 innerhalb der Ebenen weiterzugeben. Auf einer jeweiligen Modulebene 5 wird die interne Versorgungsspannung 43 über mindestens einen getakteten Spannungswandler 48, 49 entsprechend in eine dort benötigte Spannung gewandelt. Ebenfalls ist es möglich, auf der Modulebene 5 die interne Versorgungsspannung 43 direkt abzugreifen. Über die so bereitgestellten verschiedenen Spannungen auf der Modulebene 5 ist es möglich, die diskreten Bausteine sowie die Einsteckmodule 7 und deren Bausteine mit Spannung zu versorgen. Durch diese dezentrale Anordnung der einzelnen Spannungswandler 48, 49 pro Ebene ist es erfindungsgemäß möglich, das Hardwaresystem 1 beliebig modular zu erweitern, also zu konfigurieren. Insbesondere ist es möglich, ohne Modifikation einer zentralen Spannungsversorgung sowie einer Erhöhung der Redundanz das Hardwaresystem 1 beliebig wachsen zu lassen, da die jeweilige Redundanz bzw. Spannungsversorgung auf einer Modulebene 5 erfolgt.

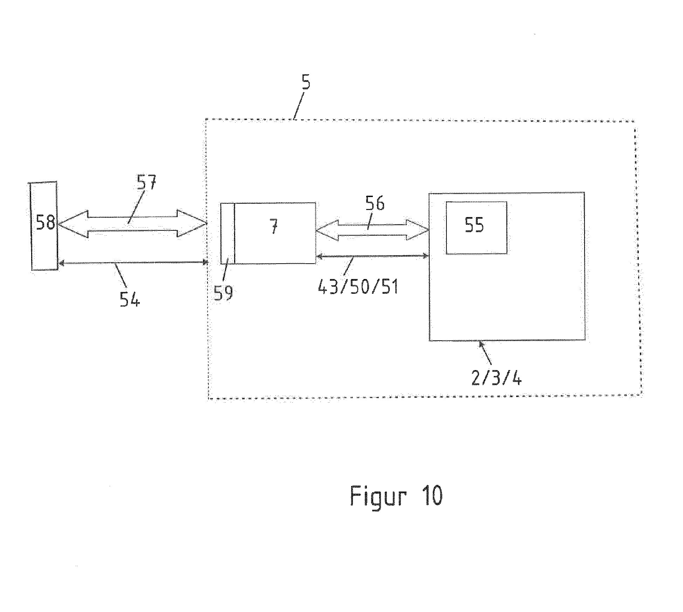

Figur 10 zeigt die Datenkommunikation sowie die Spannungsversorgung auf einer jeweiligen Modulebene 5. Hierbei ist das Grundmodul 2 oder das Zwischenmodul 3 oder das Deckelmodul 4 mit einem Controller 55 ausgestattet, der je nach Konfiguration des Hardwaresystems 1 ein Mastercontroller oder aber ein Slavecontroller sein kann. Der Controller 55 kommuniziert dabei über einen Datentransfer 56 mit dem in das jeweilige Modul 2/3/4 eingesteckten Einsteckmodul 7. Der Datentransfer 56 kann dabei ein ebeninternes Datenprotokoll oder aber auch ein zentrales Datenprotokoll des gesamten Hardwaresystems 1 verwenden. Ebenfalls erfolgt eine Spannungsversorgung von dem Modul 2/3/4 zu dem Einsteckmodul 7, dass eine interne Versorgungsspannung 43, eine Modulebenenspannung 5 Volt 50 oder aber auch eine Modulebenenspannung 3,3 Volt 51 sein kann.

Von dem Einsteckmodul 7 aus wird dann die Systemgrenze des Hardwaresystems 1 verlassen und es erfolgt ein externer Datentransfer 57 mit einem an das Einsteckmodul 7 gekoppelten externen Element 58. Das externe Element 58 kann auch von dem Einsteckmodul 7 optional mit einem entsprechenden Laststrom 54 versorgt werden. Das Einsteckmodul 7 und das externe Element 58 nutzen zum externen Datentransfer 57 insbesondere das Datenprotokoll des externen Elements 58. In dem Einsteckmodul 7 selber sind bevorzugt sowohl Treiberhardware als auch Treibersoftware zum Betreiben oder zur Kommunikation mit dem externen Element 58 vorgesehen.

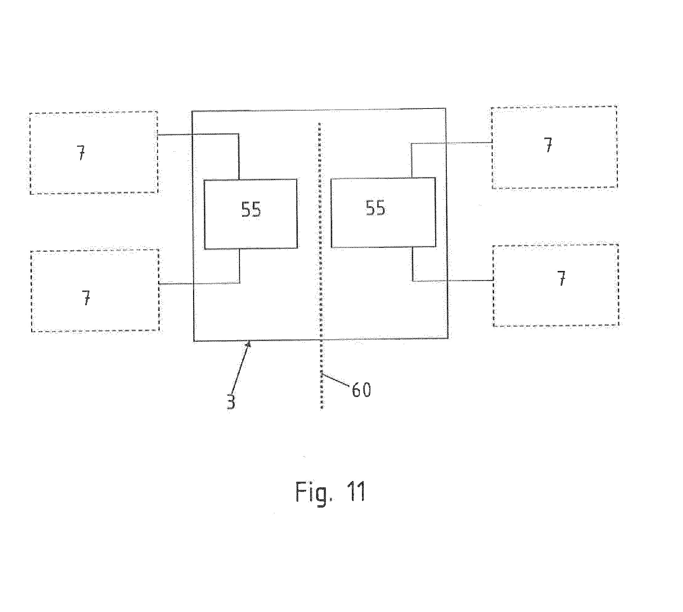

Figur 11 zeigt eine schematische Ansicht des spiegelsymmetrischen Aufbaus eines Zwischemoduls 3. An einer mittigen Spiegelebene 60 ist das Zwischenmodul 3 gespiegelt. Das Zwischenmodul 3 weist hierzu zwei Controller 55 auf, wobei jeder Controller 55 zwei Einsteckmodule 7 verwaltet. Im Rahmen der Erfindung ist es hierüber möglich, über ein Zwischenmodul 3 einen Programmablauf z. B. während eines Testzyklus, spiegelsymmetrisch parallel ablaufen zu lassen, wobei bei Ausfall einer Seite, die spiegelsymmetrische Seite dies redundant auffängt. Die Ausfallsicherheit kann beispielsweise dadurch noch weiter gesteigert werden, dass zwei Zwischenmodule 3 gespiegelt werden. Somit kann auf vier Controllern 55 der gleiche Programmablauf gefahren werden.

In besonders bevorzugter Ausführungsvariate ist jeder Controller 55 durch mindestens zwei Prozessoren, insbesondere drei, besonders bevorzugt vier, ganz besonders bevorzugt acht Prozessoren ausgebildet. Bei den Prozessoren handelt es sich besonders bevorzugt um RISC-Prozessoren. Durch den Aufbau eines Controllers 55 mit mindestens zwei Prozessoren ist es möglich, gleichzeitig zwei voneinander verschiedene Aufgaben in harter Echtzeit durchzuführen. So kann beispielsweise einer der Prozessoren die systemeigene Datenleitung, insbesondere den systemeigenen Bus auslesen bzw. überwachen, wobei der zweite Prozessor dann davon unabhängige bzw. verschiedene Aufgaben wahrnimmt. Diese Aufgaben können beispielsweise in der Kommunikation mit einem Einsteckmodul 7 und/oder einer Datenaufbereitung der Daten von dem Einsteckmodul 7 bestehen. Weiterhin können die aus dem systemeigenen Bus ausgelesenen Daten an das einsteckmodul weitergegebene werden, bzw. für dieses aufbereitet werden.

Ebenfalls können wiederum zwei Prozessoren redundant parallel arbeiten, so dass bei Ausfall eines Prozessors ein Funktionsprinzip durch den anderen Prozessor sichergestellt wird. Als besonderer Vorteil zeichnet sich bei dem erfindungsgemäßen Hardwaresystem durch den Aufbau mit mehreren Prozessoren die Arbeitsgeschwindigkeit aus. So ist es gegenüber herkömmlichen Controllern möglich, ohne Interrupt-Routinen zu arbeiten. Auch hierdurch wird wiederum die harte Echtzeitfähigkeit des erfindungsgemäßen Hardwaresystems sichergestellt. In besonders bevorzugter Ausführungsvariante werden Controller 55 mit acht Prozessoren eingesetzt, so dass sich bei einem spiegelsymmetrischen Aufbau auf einer Ebene 16 Prozessoren befinden.

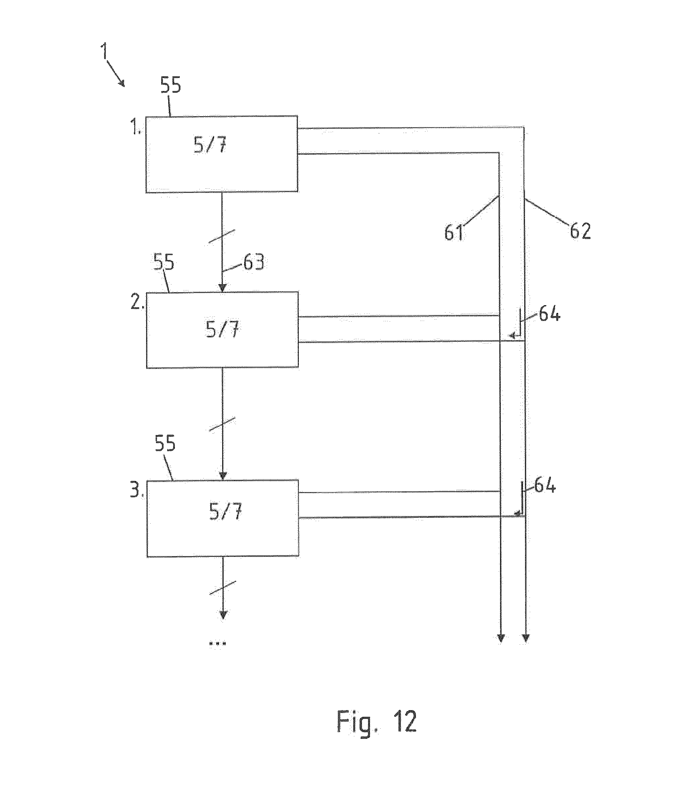

Figur 12 zeigt die erfindungsgemäße Möglichkeit der Autoadressierung des Hardwaresystems 1. Hierbei können die einzelnen Controller 55 der Modulebenen 5 oder aber auch ein jeweiliger Controller 55 eines Einsteckmoduls 7 innerhalb des Hardwaresystems 1 adressiert werden. Jeder Controller 55 muss dazu eine individuelle Nummer besitzen, um im Gesamthardwaresystem ansprechbar zu sein. Hierzu sind alle Controller 55 über Datenleitungen miteinander verbunden, die hier dargestellt in Form einer Senderleitung 61 und einer Empfängerleitung 62 ausgebildet sind. Die Controller 55 sind mit der Modularkonfiguration des Systems parallel an die Senderleitung 61 und die Empfängerleitung 62 angeschlossen.

Zur Autoadressierung müssen die Controller 55 jedoch in Reihe, also der Reihe nach, autoadressiert werden. Hierzu wird für einen ersten Controller 55 ein Resetsignal an den zweiten Controller 55 gesendet. Der erste Controller 55 bootet sich daraufhin neu. Er vertauscht seine Senderleitung 61 mit der Empfängerleitung 62, es wird also die Senderleitung 61 zur Empfängerleitung 62 und die Empfängerleitung 62 zur Senderleitung 61. Hierüber wird eine Kennung 64 an den zweiten Controller 55 gesendet. Der erste Controller 55 stellt anschließend seinen ursprünglichen Zustand von Senderdatum und Empfängerdatum wieder her. Daraufhin bootet der zweite Controller 55 neu und sendet an den dritten Controller 55 ebenfalls durch Vertauschen seiner Empfängerleitung 62 und Senderleitung 61 die Kennung 64 um plus 1 erhöht, woraufhin der dritte Controller 55 neu bootet. Die Autoadressierung kann sich folglich beliebig oft fortsetzen, wodurch das Hardwaresystem 1 mit durchaus bis zu mehr als 50 Controllern 55 erweiterbar ist. Die Controller 55 können untereinander mit einer Resetleitung 63 gekoppelt sein

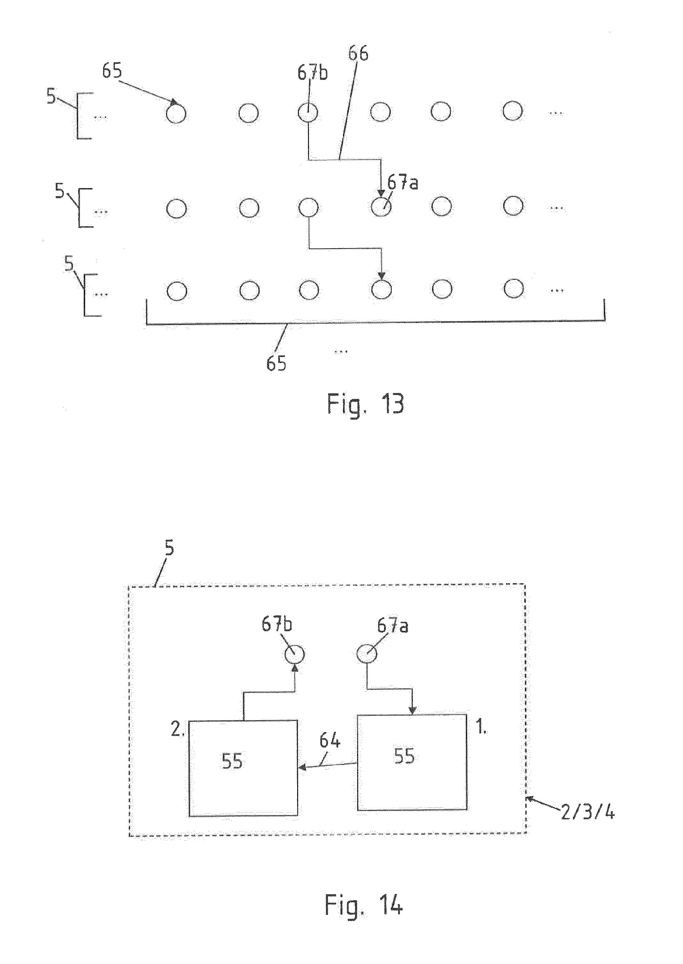

Damit die Controller ebenenübergreifend in Reihe schaltbar sind, muss ein jeweiliger Pfostenfeldstecker 65 einer Modulebene 5 einen Pinnversatz 66 der Resetleitung 67, die in Resetin 67a und Resetout 67b aufgeteilt ist, aufweisen. Hierdurch wird ebenenübergreifend, bei beliebiger modularer Erweiterungsmöglichkeit sichergestellt, dass das Resetsignal in Reihe weitergegeben wird, woraufhin sich die einzelnen Controller 55 fortlaufend autoadressieren. Dargestellt ist dies in Figur 13.

Figur 14 zeigt ergänzend, wie sich auf einer Modulebene 5, beispielsweise eines Grundmoduls 2 oder eines Zwischenmoduls 3 oder eines Deckelmoduls 4 zwei angeordnete Controller 55 entsprechend nacheinander autoadressieren. Zunächst kommt das Resetsignal über die Resetleitung 67 resetin 67a an, woraufhin der auf die Resetleitung 67 resetin 67a folgende erste Controller 55 sich bootet und das Resetsignal und die Kennung 64 um n plus 1 erhöht, an den zweiten Controller 55 auf der Modulebene 5 weitersendet, von wo aus das Resetsignal dann über die Restleitung 67 resetout auf die nächste, nicht näher dargestellte Modulebene 5 weitergegeben wird.

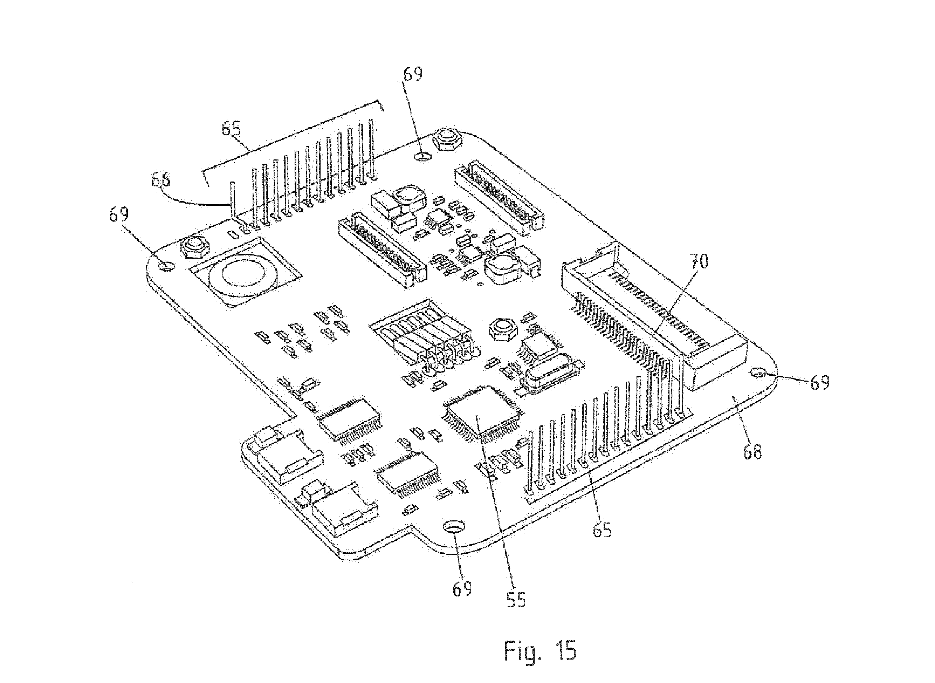

Figur 15 zeigt weiterhin eine Elektronikplatine 68, die dazu geeignet ist, in dem Gehäuse des erfindungsgemäßen Hardwaresystems 1 angeordnet zu werden. Die in Figur 15 gezeigte Platine eignet sich insbesondere zur Anordnung in dem Deckelmodul 4. Die Platine weist diverse Elektronikbauteile sowie mindestens einen Controller 55 auf. In Eckbereichen weist die Platine wiederum Montagelöcher 69 auf, die auf den Montagesockeln 25 in den einzelnen Modulebenen 5 anordnenbar sind und mit diesen verschraubbar sind. Ferner weist die Elektronikplatine 68 einen Pfostenfeldstecker 65 auf, wobei der auf die Bildebene bezogene hintere Pfostenfeldstecker einen Pinversatz 66 aufweist. Der Pinversatz 66 wird zur Autoadressierung genutzt. Ebenfalls ist ein Einsteckschachtstecker auf der Elektronikplatine angeordnet, in den das in einem Einsteckschacht 10 eingesteckte Einsteckmodul 7 lösbar steckbar ist.

### Bezugszeichen:

- 1 -: Hardwaresystem
- 2 -: Grundmodul
- 3 -: Zwischenmodul
- 4 -: Deckelmodul
- 5 -: Modulebene zu 2 bis 4
- 6 -: Zwischenschicht
- 7 -: Einsteckmodul
- 8 -: Kartenabschnitt zu 7
- 9 -: Modulabschnitt zu 7
- 10 -: Einstecköffnung zu 3
- 11 -: Stecker
- 12 -: Display
- 13 -: Taster
- 14 -: Oberseite
- 15 -: vordere Einsteckseite
- 16 -: hintere Einsteckseite
- 17 -: vordere Seitenwand
- 18 -: hintere Seitenwand
- 19 -: Unterseite
- 20 -: Spannungsanschluss
- 21 -: abgerundete Ecke
- 22 -: Gehäusewandung zu 15/16
- 23 -: Gehäusewandung zu 17/18
- 24 -: Ausnehmung
- 25 -: Montagesockel
- 26 -: innere Rundung
- 27 -: Montagelöcher zu 25
- 28 -: Montagelöcher zu 23/22
- 29 -: Magnet
- 30 -: Montageunterseite
- 31 -: Steckeröffnung
- 32 -: Öffnung zu 20
- 33 -: Adapterstück zu 20
- 34 -: Schraubverbindung
- 35 -: Fuß
- 36 -: Steckeröffnung
- 37 -: Anlagefläche
- 38 -: Einsteckmodulmagnet
- 39 -: D-Sub-Stecker
- 40 -: Pol
- 41 -: Sicherungsschraube
- 42 -: externe Versorgungsspannung
- 43 -: interne Versorgungsspannung
- 44 -: Netzteil
- 45 -: Akkumulator
- 46 -: Kraftfahrzeugbordnet
- 47 -: Versorgungsleitung
- 48 -: Spannungswandler 5 Volt
- 49 -: Spannungswandler 3,3 Volt
- 50 -: Modulebenenspannung 5 Volt
- 51 -: Modulebenenspannung 3,3 Volt
- 52 -: Lastversorgungsspannung
- 53 -: Leistungstreiber
- 54 -: Laststrom
- 55 -: Controller
- 56 -: Datentransfer
- 57 -: externer Datentransfer
- 58 -: externes Element
- 59 -: Treiber
- 60 -: Spiegelebene
- 61 -: Senderleitung
- 62 -: Empfängerleitung
- 63 -: Resetleitung
- 64 -: Kennung
- 65 -: Pfostenfeldstecker
- 66 -: Pinnversatz
- 67 -: Resetleitung
- 67a -: Resetin
- 67b -: Resetout
- 68 -: Elektronikplatine
- 69 -: Montagelöcher
- 70 -: Einsteckschacht

- L -: Länge
- B -: Breite

## Patentansprüche

1. Hardwaresystem (1) zur Modellbildung, Messung, Prüfung, Regelung und/oder Steuerung von elektrischen Schaltkreisen und/oder Datennetzen und/oder Sensoren und/oder Aktoren, insbesondere zum Einsatz in Automotiveanwendungen, aufweisend ein Grundmodul (2) mit in das Grundmodul (2) einsteckbaren Einsteckmodulen (7), **dadurch gekennzeichnet, dass** das Einsteckmodul (7) lösbar in das Grundmodul (2) einsteckbar ist und über das Einsteckmodul (7) ein externer Sensor und/oder Aktor ansteuerbar ist oder dass über das Einsteckmodul (7) ein externes Datennetz auslesbar ist.

2. Hardwaresystem nach Anspruch 1, **dadurch gekennzeichnet, dass** das Grundmodul (2) mit Zwischenmodulen (3) schichtartig und/oder in turmbauweise erweiterbar ist, wobei in das Zwischenmodul (3) Einsteckmodule (7) einsteckbar sind.

3. Hardwaresystem nach Anspruch 2, **dadurch gekennzeichnet, dass** die Zwischenmodule (3) und das Grundmodul (2) und/oder die Einsteckmodule (7) eine systeminterne Adresse zugewiesen bekommen, so dass ein jeweiliges Modul (2/3/4) über einen systemeigenen Bus, insbesondere SPI Bus, ansteuerbar ist.

4. Hardwaresystem nach einem der Ansprüche 1 bis 3, **dadurch gekennzeichnet, dass** zwischen den Modulen (2/3/4) eine Steckverbindung ausgebildet ist, wobei eine Leitung der Steckverbindung als Resetleitung (67) ausgebildet ist und modulübergreifend die Resetleitung (67) einen Pinversatz (66) aufweist, so dass die Module (2/3/4) in Reihe geschaltet sind.

5. Hardwaresystem nach einem der Ansprüche 1 bis 4, **dadurch gekennzeichnet, dass** ein Einsteckmodul (7) als Drahtlosdatenübertragungsmodul ausgebildet ist.

6. Hardwaresystem nach einem der Ansprüche 1 bis 5, **dadurch gekennzeichnet, dass** ein Einsteckmodul (7) als Regelelement ausgebildet ist, so dass es Lastströme (54) schalten und/oder regeln kann.

7. Hardwaresystem nach einem der Ansprüche 1 bis 6, **dadurch gekennzeichnet, dass** ein Treiberelement und eine Treibersoftware für einen Aktor und/oder einen Sensor in dem Einsteckmodul (7) vorhanden sind.

8. Hardwaresystem nach einem der Ansprüche 1 bis 7, **dadurch gekennzeichnet, dass** das Einsteckmodul (7) aus einem Kartenabschnitt (8) und einem Modulabschnitt (9) ausgebildet ist, wobei der Kartenabschnitt (8) in ein Gehäuse des Hardwaresystems (1) einsteckbar ist und mit dem Grundmodul (2) oder dem Zwischenmodul (3) koppelbar ist und wobei der Modulabschnitt (9) sich außerhalb des Gehäuses befindet.

9. Hardwaresystem nach Anspruch 8, **dadurch gekennzeichnet, dass** der Modulabschnitt (9) einen Spannungswandler aufweist, wobei der Spannungswandler eine Systemspannung des Hardwaresystems (1) und/oder eine externe Spannung weiterleitet und/oder wandelt.

10. Hardwaresystem nach Anspruch 8 oder 9, **dadurch gekennzeichnet, dass** der Modulabschnitt (9) eine Steckverbindung aufweist, vorzugsweise einen D-SUB Stecker.

11. Hardwaresystem nach einem der Ansprüche 8 bis 10, **dadurch gekennzeichnet, dass** der Modulabschnitt (9) einen Netzwerkanschluss aufweist, vorzugsweise zum Anschluss an eine Datennetzleitung, insbesondere ein Bus System.

12. Verwendung eines Hardwaresystems (1) nach mindestens einem der Ansprüche 1 bis 11, **dadurch gekennzeichnet, dass** das Hardwaresystem (1) zur Erprobung von Prototypenfahrzeugen verwendet wird.

13. Verwendung nach Anspruch 12, **dadurch gekennzeichnet, dass** das Hardwaresystem (1) als Gateway zwischen verschiedenen Bus Systemen genutzt wird.

14. Verwendung nach Anspruch 12 oder 13, **dadurch gekennzeichnet, dass** verschiedene Bussignale simuliert werden und/oder dass ein vernetztes Steuergerät simuliert wird und/oder dass Messdaten erfasst werden und/oder dass Aktoren geregelt und/oder gesteuert werden.

15. Verwendung eines Hardwaresystem (1) nach mindestens einem der Ansprüche 1 bis 11 für Prüfstände und/oder Prüfvorrichtungen und/oder als Handheld Gerät zum Ansteuern und Prüfen von einzelnen Systemkomponenten, wobei eine Systemumgebung von dem Hardwaresystem (1) simuliert wird.

16. Verwendung eines Hardwaresystems (1) nach mindestens einem der Ansprüche 1 bis 11 als frei programmierbares Kleinseriensteuergerät und/oder Hardwareschnittstelle zu einer Modellierungssoftware.

17. Verfahren zur Autoadressierung eines Hardwaresystems (1) nach mindestens einem der Ansprüche 1 bis 11, **dadurch gekennzeichnet, dass** die Autoadressierung bei Neustart und/oder modularer Erweiterung des Hardwaresystems (1) mit einem Zwischenmodul (3) durchgeführt wird, wobei das Grundmodul (2) und jedes Zwischenmodul (3) einen Controller (55) aufweisen und jedem Controller (55) eine individuelle Adresse zugeordnet wird.

18. Verfahren nach Anspruch 17, **dadurch gekennzeichnet, dass** durch den Controller (55) des Grundmoduls (2) ein Resetsignal gesendet wird.

19. Verfahren nach Anspruch 17 oder 18, **dadurch gekennzeichnet, dass** das Resetsignal an den Controller (55) des nächsten benachbarten Zwischenmoduls (3) gesendet wird, wobei sich der Controller (55) des Zwischenmoduls (3) daraufhin neustartet.

20. Verfahren nach einem der Ansprüche 18 oder 19, **dadurch gekennzeichnet, dass** der Controller (55) des ersten Zwischenmoduls (3) das Resetsignal an einen Controller (55) seines direkt benachbarten Zwischenmoduls (3) weiter sendet.

21. Verfahren nach einem der Ansprüche 17 bis 20, **dadurch gekennzeichnet, dass** jeder Controller (55) eine Empfängerleitung und eine Senderleitung aufweist, wobei zur Durchführung der Autoadressierung jeder Controller (55) seine Senderleitung und Empfängerleitung vertauscht und bei seinem eigenen Neustart wieder den Ursprungszustand von Senderleitung und Empfängerleitung herstellt.
